(19) Europäisches Patentamt / European Patent Office / Office européen des brevets

(11) **EP 3 356 790 B1**

(12) **EUROPÄISCHE PATENTSCHRIFT**

(45) Veröffentlichungstag und Bekanntmachung des Hinweises auf die Patenterteilung:
**03.11.2021  Patentblatt 2021/44**

(51) Int Cl.:
**G01N 15/00** *(2006.01)*    **G01N 21/64** *(2006.01)*

(21) Anmeldenummer: **16787738.0**

(22) Anmeldetag: **30.09.2016**

(86) Internationale Anmeldenummer:
**PCT/EP2016/073471**

(87) Internationale Veröffentlichungsnummer:
**WO 2017/055583 (06.04.2017 Gazette 2017/14)**

(54) **SYSTEM UND VERFAHREN FÜR DIE OPTISCHE MESSUNG DER STABILITÄT UND DER AGGREGATION VON PARTIKELN**

SYSTEM AND METHOD FOR OPTICALLY MEASURING THE STABILITY AND AGGREGATION OF PARTICLES

SYSTÈME ET PROCÉDÉ DE MESURE OPTIQUE DE LA STABILITÉ ET DE L'AGRÉGATION DE PARTICULES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.10.2015  EP 15188017**

(43) Veröffentlichungstag der Anmeldung:
**08.08.2018  Patentblatt 2018/32**

(73) Patentinhaber: **NanoTemper Technologies GmbH**
**81369 München (DE)**

(72) Erfinder:
 • **BAASKE, Philipp**
   **81379 München (DE)**
 • **DUHR, Stefan**
   **88167 Gestratz (DE)**
 • **BREITSPRECHER, Dennis**
   **78183 Hüfingen (DE)**
 • **DERIX, Jonathan**
   **85716 Unterschleißheim (DE)**

(74) Vertreter: **Vossius & Partner**
**Patentanwälte Rechtsanwälte mbB**
**Siebertstrasse 3**
**81675 München (DE)**

(56) Entgegenhaltungen:
**EP-A1- 0 029 662    EP-A1- 0 720 747**
**US-A1- 2014 234 865**

 • **A.S.G. CURTIS: "Effect of pH and Temperature on Cell Re-aggregation", NATURE, Bd. 200, Nr. 4912, 21. Dezember 1963 (1963-12-21), Seiten 1235-1236, XP055337464, United Kingdom ISSN: 0028-0836, DOI: 10.1038/2001235b0**

## Beschreibung

Die Erfindung betrifft generell eine Vorrichtung bzw. ein System und ein Verfahren für die optische Messung der Stabilität von Partikeln. Insbesondere betrifft die Erfindung ein System und ein Verfahren mit dem optisch nicht nur die Stabilität von Partikeln, sondern auch die Aggregation von Partikeln gemessen werden kann. Erfindungsgemäß kann vorzugsweise die Stabilität und die Aggregation der Partikel mit einer einzigen Vorrichtung gemessen werden, vorzugsweise gleichzeitig bzw. nahezu gleichzeitig.

## HINTERGRUND DER ERFINDUNG

Da Wirkstoffe, wie z.B. Antikörper, so entwickelt wurden, dass sie nur in ihrer nativen Form aktiv sind, sind denaturierte Wirkstoffe oft nicht wirksam und zu vermeiden. Denaturierung bezeichnet eine strukturelle Veränderung von Biomolekülen, wie zum Beispiel bei Proteinen (Eiweiße), die in den meisten Fällen mit einem Verlust der biologischen Funktion dieser Moleküle verbunden ist. Eine Denaturierung kann entweder auf physikalische oder auf chemische Einflüsse zurückzuführen sein. Es müssen daher Wirkstoff-Formulierungen entwickelt werden, die die Denaturierung der Medikamente verhindern, diese also z.B. thermisch, chemisch und/oder zeitlich stabilisieren.

Auch eine Aggregation bzw. Aggregierung von Wirkstoffen kann zu einer Unwirksamkeit führen. Zudem können aggregierte und/oder denaturierte Partikel, beispielsweise aggregierte Antikörper, im Körper eine Reaktion des Immunsystems auslösen und müssen deshalb in Medikamenten vermieden bzw. deren Anteil im Medikament minimiert werden.

Denaturierung von Partikeln, beispielsweise Antikörpern, an sich ist zu vermeiden, weil sie die Wirksamkeit reduziert. Die Aggregation von Partikeln, beispielsweise Antikörpern, an sich ist zu vermeiden, da sie eine Reaktion des Immunsystems hervorruft und auch zu einer Reduktion der Wirksamkeit führen kann.

Es ist oft nicht klar warum ein Partikel aggregiert und/oder denaturiert: Aggregiert ein Partikel, weil er denaturiert, d.h. nicht in seiner nativen Form vorliegt, oder aggregiert er in seiner nativen Form und denaturiert dann? Für eine umfassende Charakterisierung der Partikel reicht es daher oft nicht aus nur die Aggregation oder nur die Denaturierung getrennt voneinander zu analysieren.

Mit dem erfindungsgemäßen System und Verfahren kann sowohl die Denaturierung als auch die Aggregation von Partikeln gemessen werden. Insbesondere kann mit dem erfindungsgemäßen System und Verfahren quasi gleichzeitig (im Wesentlichen gleichzeitig) oder gleichzeitig sowohl die Denaturierung als auch die Aggregation von Partikeln gemessen werden.

Die Denaturierung der Partikel ist ein *"intra-Partikel"* Vorgang und kann im erfindungsgemäßen Verfahren und System mittels der Messung der intrinsischen Partikel Fluoreszenz (beispielsweise Tryptophan Fluoreszenz, Tyrosin Fluoreszenz) gemessen werden. Gleichzeitig kann die Aggregation der Partikel, ein *"inter-Partikel"* Vorgang, der die Größe der Partikel ändert, mittels Streuung von nicht absorbiertem Licht gemessen werden.

Da die Lichtstreuung, z.B. die statische Lichtstreuung im Falle der Rayleigh Streuung von der sechsten Potenz der Partikelgröße (Radius) abhängt, eignet sie sich sehr gut, um Größenänderungen von Partikeln und damit die Aggregation von Partikeln zu messen. Dieses Lichtstreuungs-Verfahren ist bekannt und wird von vielen Geräten und Verfahren benutzt. Insbesondere messen die aus dem Stand der Technik bekannten Geräte das Streulicht der Partikel bei bestimmten Raumwinkeln, d.h. den Anteil an Licht der von einem Partikel in einen bestimmten Raumwinkel gegenüber dem einfallenden Licht gestreut wird. Je größer die Partikel und je kleiner die Wellenlänge desto größer wird die Intensität dieses Streulichts für einen fixen, geeignet gewählten Winkel Ein derartiges Verfahren ist beispielsweise in der Anmeldung US 2014/0234865 A1 beschrieben.

Über eine Zunahme des Streulichts, z.B. während der Erhöhung der Temperatur, können diese Verfahren deshalb auf eine Größenänderung und damit Aggregation der Partikel schließen. Einem Fachmann auf dem Gebiet der Lichtstreuungs-Verfahren ist bewusst, dass vermieden werden soll, dass das Anregungslicht, das auf zu untersuchende Partikel gestrahlt wird, in die Detektionsoptik kommt. Ein Fachmann wird entsprechende Vorrichtungen stets so konstruieren, dass eine direkte Detektion dieses Anregungslichtes vermieden bzw. das Anregungslicht blockiert wird, was einen erheblichen technischen Aufwand erfordert. Beispielsweise wird in dem Patent DE 10 2007 031 244 beschrieben, dass Reflexionen bei Streulichtmessungen unerwünscht sind und auch Reflexionen an Glasküvetten zu Problemen führen können.

Es besteht daher der Bedarf an einem verbesserten oder alternativen System bzw. einem verbesserten bzw. alternativen Verfahren zur Messung der Stabilität und der Aggregation von Partikeln.

## ZUSAMMENFASSUNG DER ERFINDUNG

Die erfindungsgemäße Vorrichtung sowie das erfindungsgemäße Verfahren werden durch die Merkmale der unabhängigen Ansprüche definiert. Vorteilhafte Ausgestaltungen ergeben sich aus den Unteransprüchen.

Die Erfindung betrifft ein Verfahren zur optischen Messung bzw. Bestimmung der Stabilität und/oder der Aggregation von Partikeln in einer flüssigen Probe, die sich in einem Probenbehälter befindet. Erfindungsgemäß kann die Aggregation unabhängig von der Stabilität gemessen werden; vorzugsweise werden jedoch sowohl Aggregation als auch Stabilität bestimmt. Das erfindungsgemäße Verfahren umfasst mindestens einen der folgenden Schritte.

Die Probe wird mit Licht bzw. einem Lichtstrahl einer ersten Wellenlänge bestrahlt, insbesondere um die Partikel fluoreszent anzuregen. Das Licht der ersten Wellenlänge ist somit ein Fluoreszenz-Anregungslicht. Um die Fluoreszenz der Probe zu bestimmen, wird das Fluoreszenzlicht, das von der Probe emittiert wird, gemessen. Typischerweise unterscheidet sich die Wellenlänge des Fluoreszenzlichts von der ersten Wellenlänge des Fluoreszenz-Anregungslichts. Basierend auf der gemessenen Helligkeit bzw. Intensität des Fluoreszenzlichts kann eine Aussage über die Stabilität der Partikel getroffen werden. Vorzugsweise misst der Detektor die Fluoreszenz mit Fluoreszenz-Anregungslicht in einem Wellenlängenbereich von 260nm bis 300nm, mehr bevorzugt in einem Wellenlängenbereich von 270nm bis 290nm und das Fluoreszenz-Emissionslicht in einem Wellenlängenbereich von 320nm bis 380nm.

Die Aggregation von Partikeln wird bestimmt indem die Probe mit Licht einer zweiten Wellenlänge bestrahlt wird, vorzugsweise mit einer ersten Intensität $I_0$. Eine erste bzw. zweite Wellenlänge kann erfindungsgemäß einer exakten Wellenlänge entsprechen, wie sie beispielsweise von einem Laser geliefert wird. Der Begriff der ersten und zweiten Wellenlänge kann erfindungsgemäß aber auch eine "mittlere" Wellenlänge bzw. "zentrale" Wellenlänge sein, d.h. im Sinne von einem Wellenlängenbereich. Beispielsweise werden Wellenlängenbereiche von einer Lichtquelle ausgestrahlt, wenn es sich nicht um einen Laser handelt. Erfindungsgemäß werden bevorzugt LEDs verwendet die über einen schmalen oder großen Wellenlängenbereich Licht emittieren. Um den Bereich der Wellenlänge einzugrenzen wird vorzugsweise ein Bandpass Filter = "Anregungsfilter" in den Strahlengang eingebaut. Beispielsweise kann ein entsprechender Bandpassfilter eine Bandpassbreite zwischen 30nm und 1nm haben, um den Anregungswellenlängenbereich zu erhalten, der erwünscht ist. Dies ist insbesondere bei der Fluoreszenz bevorzugt, so dass das Licht, das von der LED emittiert wird, auf einen Wellenlängenbereich beschränkt wird, der nicht im Wellenlängenbereich der Fluoreszenz-Emissions-Detektion liegt. Zudem ist es auch bevorzugt, für die Extinktionsmessung eine LED zu verwenden. Auch hier kann analog ein Bandpassfilter mit einer geeigneten Bandpassbreite verwendet werden, um den Wellenlängenbereich, der auf die Probe emittiert wird, auf eine "zweite Wellenlänge" (zweite Wellenlängenbereich) zu beschränken.

Mit der zweiten Wellenlänge wird vorzugsweise die Streuung der Partikel bestimmt. Erfindungsgemäß wird das Extinktionslicht bei der zweiten Wellenlänge gemessen, wobei das Verhältnis des eingestrahlten bzw. einfallenden Lichts $I_0$ der zweiten Wellenlänge, das den Probenbehälter durchläuft, und des austretenden Lichts I (Intensität I), vorzugsweise ebenfalls bei der zweiten Wellenlänge, die Extinktion beschreibt. Vorzugsweise durchläuft die eintretende Strahlung $I_0$ den Probenbehälter, wird reflektiert, durchläuft den Probenbehälter im Wesentlichen entgegengesetzt zur einfallenden Richtung und tritt dann als Licht I aus, das im Sinne der vorliegenden Erfindung auch als Extinktionslicht bezeichnet wird. Basierend auf der gemessenen Helligkeit bzw. Intensität I des austretenden Lichtes (Extinktionslicht), insbesondere im Verhältnis zur Intensität des einfallenden Lichts $I_0$, kann eine Aussage über die Stabilität der Partikel getroffen werden. Erfindungsgemäß kann eine reine Aggregationsmessung auch ohne eine oben genannte Fluoreszensmessung durchgeführt werden.

Vorzugsweise wird die zweite Wellenlänge so ausgewählt, dass die zu untersuchenden Partikel in der Probe bei dieser Wellenlänge nicht absorbiert oder nur sehr geringfügig absorbiert werden, vorzugsweise weniger als 10%, weiter bevorzugt weniger als 5%, weiter bevorzugt weniger als 4%, 3%, 2% oder 1%. Weiter bevorzugt weniger als 0,1%. Zudem ist es bevorzugt, dass die Wellenlänge in Bezug auf das Absorptionsverhalten der Partikel ausgewählt wird, und nicht in Bezug auf die gesamte "Probe" bzw. "Probenflüssigkeit", da eventuell Zusätze in der Probe bzw. Probenflüssigkeit vorhanden sind, die bei der ausgewählten Flüssigkeit absorbieren. Da die Erfindung jedoch die Stabilität und Aggregation der Partikel untersucht, kann das Absorptionsverhalten der restlichen Komponenten als "konstant" angenommen werden.

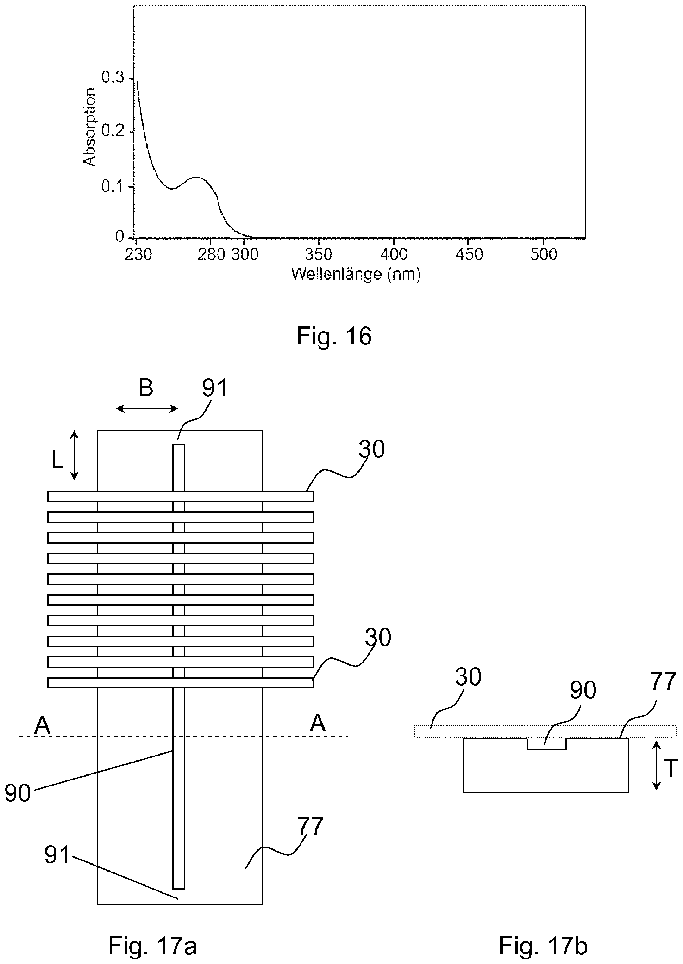

Beispielsweise ist von Proteinen bekannt, dass sie im Bereich 200nm bis 300nm Licht absorbieren und zwar aufgrund ihrer Peptidbindungen (Maximum der Absorption bei ca. 220nm) und ihrer Aminosäuren (Maximum der Absorption bei ca. 280nm). Daher wird erfindungsgemäß vorzugsweise Licht einer Wellenlänge größer 300nm eingesetzt (siehe Figur 16). Vorzugsweise sind die erste und zweite Wellenlänge unterschiedlich. Alternativ können die erste und zweite Wellenlänge auch gleich sein.

Für die Fluoresenzmessung wird zumindest eine erste Wellenlänge verwendet. Es ist erfindungsgemäß auch möglich, dass zusätzlich zur ersten Wellenlänge eine weitere Wellenlänge für die Fluoreszenzmessung verwendet wird. So kann beispielsweise eine erste Fluoreszenz bei einer Wellenlänge von 280nm angeregt werden und eine zweite Fluoreszenz bei einem zweiten Fluoreszenzkanal bei 632nm angeregt werden.

Entsprechend kann erfindungsgemäß auch mindestens eine zweite Wellenlänge für die Messung der Extinktion verwendet werden. Beispielsweise kann eine Extinktion bei zwei verschiedenen Wellenlängen gemessen werden; beispielsweise bei 385nm und 532nm. Es ist dann beispielsweise möglich, ein Verhältnis der Messwerte bei den beiden Wellenlängen zu bilden und auszuwerten, um z.B, Mie-Streuung zu quantifizieren.

Mit anderen Worten, erfindungsgemäß ist es möglich zwei oder mehr Fluoreszenzkanäle und/oder zwei oder mehr Extinktionskanäle zur Bestimmung zu verwenden.

Das erfindungsgemäße Verfahren bzw. erfindungsgemäße System verfolgt im Vergleich zu klassischen Lichtstreumessungen einen völlig anderen Ansatz. Erfindungsgemäß wird vorzugsweise das Licht gemessen, das nicht gestreut wird. Vorzugsweise wird zudem Licht einer Wellenlänge verwendet, die nicht von den Partikeln absorbiert wird. D.h. das gemessene Signal nimmt ab, wenn die Streuung durch eine Erhöhung der Partikelgröße zunimmt. Diese erfindungsgemäße Messtechnik wird vorzugsweise mit einer speziellen Fluoreszenzoptik kombiniert, die vorzugsweise eine schnellere, präzisere und robustere simultane Detektion von Aggregation (durch Extinktion) und Detektion von Denaturierung bzw. Proteinentfaltung (durch Fluoreszenz) in hohem Durchsatz ermöglicht.

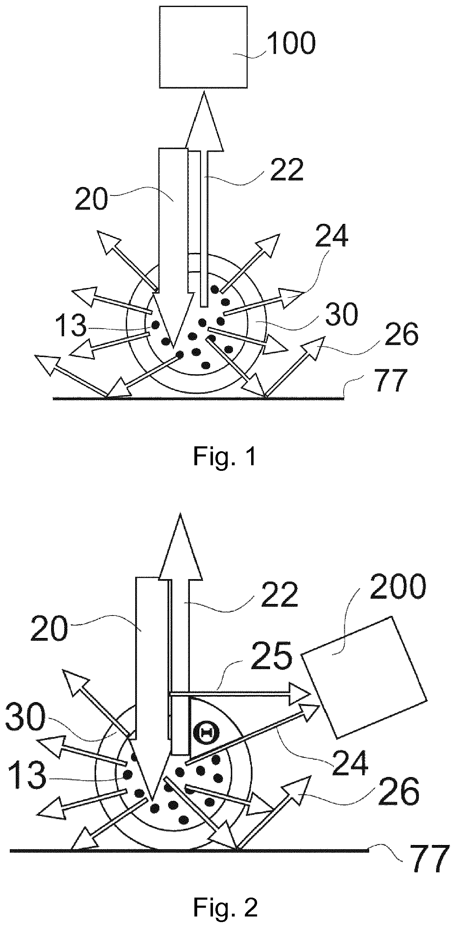

Das erfindungsgemäße Verfahren wird vorzugsweise so ausgeführt, dass das Anregungslicht für die Aggregationsmessung den Probenbehälter 2x durchläuft und in den Detektor zurückreflektiert wird (vgl. Fig. 1). Erfindungsgemäß ist es auch möglich, dass das Anregungslicht für die Aggregationsmessung nur einmal den Probenbehälter durchquert und dann die einfache Transmission gemessen wird. Sowohl die direkte Transmission als auch die Transmission nach Reflexion bedeutet, dass ein "Restanteil" des Anregungslichtes gemessen wird, d.h., genau das, was in den bekannten Verfahren Umständen vermieden werden sollte.

Im Prinzip wird erfindungsgemäß eine Extinktion gemessen In der Optik ist die Extinktion oder optische Dichte die wahrnehmungsgerecht logarithmisch formulierte Opazität $O$, und damit ein Maß für die Abschwächung einer Strahlung (zum Beispiel Licht) nach Durchqueren eines Mediums. Mit $I_0$ als einfallender Strahlung und $I$ als austretender Strahlung beschreibt die Extinktion $E$ als logarithmische Größe den Transmissionsgrad $\tau$:

$$E_\lambda = -\log_{10} \frac{I}{I_0} = \log_{10} \frac{I_0}{I} = \log_{10} \frac{1}{\tau_\lambda} = \log_{10} O_\lambda$$

An der Abschwächung/Extinktion sind im Allgemeinen die Prozesse Absorption, Streuung, Beugung und Reflexion beteiligt. Da erfindungsgemäß vorzugsweise Wellenlängen verwendet werden, die von den zu untersuchenden Partikeln (z.B. von Biomolekülen) nicht absorbiert werden, und andere Einflussgrößen wie Reflexion und Beugung vorzugsweise konstant gehalten werden, wird erfindungsgemäß im Wesentlichen die Abschwächung basierend auf der reinen Wegstreuung gemessen.

Vorteilhaft an dieser Herangehensweise ist insbesondere, dass sich dieses „Wegstreuungs" Messprinzip gut in eine (einzelne) Optik zur Messung der intrinsischen Partikel-Fluoreszenz integrieren lässt. Somit kann mit ein und derselben Optik sowohl die Denaturierung der Partikel im nm-Maßstab, als auch deren Aggregation im nm-$\mu$m Maßstab detektiert bzw. gemessen werden. Die beiden Messungen können je nach Ausführungsform sequentiell, kurz hintereinander oder sogar gleichzeitig erfolgen.

Erfindungsgemäß werden die zu untersuchenden Proben vorzugsweise in Kapillaren untersucht, was zudem den bevorzugten Vorteil hat, dass die Kapillaren schnell in die gewünschte Messposition gebracht werden können, wodurch ermöglicht wird, dass eine Vielzahl von Proben parallel analysiert werden kann. Dies gewährleistet zudem eine große Datenpunktdichte die es erlaubt, selbst kleine Signaländerungen präzise zu erfassen und auszuwerten, was durch bestehende Methoden bisher nicht gewährleistet wird.

Erfindungsgemäß können mehrere Kapillaren direkt auf ein Trägerelement der Messvorrichtung gelegt werden. Gemäß einer weiteren Ausführungsform können mehrere Kapillaren auch auf einem separaten Träger angeordnet sein, wodurch auch eine halbautomatische bzw. automatische Befüllung und/oder Messung ermöglicht wird.

Die Anmelderin der vorliegenden Erfindung, NanoTemper Technologies GmbH, entwickelt und vertreibt Messgeräte, bei denen Flüssigkeiten innerhalb einer Kapillare optisch untersucht werden. Es ist zudem bekannt, dass man eine einzelne Kapillare mit der Hand nimmt, in eine Flüssigkeit eintaucht und dann einzeln auf einen Träger ablegt und dann ins Messgerät schiebt. Dieses Verfahren zum Befüllen einzelner Kapillaren wird beispielsweise in einem Video von NanoTemper Technologies GmbH, das auf https://www.youtube.com unter dem Titel "NanoTemper Technology: Learn about the handling of NT.115" veröffentlicht ist, gezeigt. Das individuelle Befüllen ist für bestimmte Einzelproben vorteilhaft, jedoch benötigt dieses Verfahren für größere Mengen von Proben viele Handlungsschritte die nicht ohne weiteres automatisierbar sind.

In der Anmeldung EP 2 572 787, die von der gleichen Anmelderin wie die vorliegende Erfindung eingereicht wurde, werden Kapillaren beschrieben, die mit Hilfe von magnetischen Kräften an einem Träger gehalten werden. Dies ermöglicht unter anderem eine einfachere und/oder genauere Positionierung der einzelnen Kapillare auf dem Träger. Mit anderen Worten, das individuelle Befüllen der Einzelkapillaren ist weiter bevorzugt, jedoch wird der darauf folgende Handlungsschritt durch die magn. Kräfte unterstützt.

Schließlich wird in der Anmeldung EP 2 848 310 ein separater Träger für Kapillaren beschrieben, wodurch auch eine halbautomatische bzw. automatische Befüllung und/oder Messung ermöglicht wird. Insbesondere können diese Träger auch für das erfindungsgemäße Verfahren verwendet werden, was den zusätzlichen Vorteil bietet, dass die mehreren Kapillaren neben der effizienten Befüllung auch sehr schnell gescannt werden können.

Im Folgenden werden einige Begriffe, wie sie im Sinne der vorliegenden Anmeldung zu verstehen sind, definiert.

**Partikel**

Partikel im Sinne der vorliegenden Anmeldung sind, ohne darauf beschränkt zu sein, vorzugsweise: Wirkstoffe, Biomoleküle im Allgemeinen, beispielsweise Proteine, Antikörper, Membranproteine, Membranrezeptoren, Peptide, Nukleotide, DNA, RNA, Enzyme; Molekülfragmente, "small molecules", Zucker, organische Verbindungen, anorganische Verbindungen; Vesikel, Viren, Bakterien, Zellen, Mizellen, Liposomen, Gewebeproben, Gewebeschnitte, Membranpräparationen, Microbeads und/oder Nanopartikel.

**Fluoreszenzmessung**

Der Partikel, vorzugsweise Protein, kann chemisch oder thermisch denaturiert werden und interne strukturelle Änderungen können durch intrinsische Fluoreszenz, beispielsweise Tryptophan-Fluoreszenz, Tyrosin-Fluoreszenz, Phenylalanin-Fluoreszenz, vorzugsweise Tryptophan-Fluoreszenz im Falle von Proteinen gemessen werden. Dabei können die strukturellen/internen Änderungen des Partikels über Änderungen der Fluoreszenzintensität oder Verschiebung von Fluoreszenzmaxima, oder Änderungen der Fluoreszenzlebensdauer, etc. detektiert werden. Auch der sogenannte Schmelzpunkt des zu untersuchenden Partikels, z.B. Proteins, kann so bestimmt werden. Der Schmelzpunkt ist dabei als der Zustand definiert, an dem der zu untersuchende Partikel, z.B. Protein, zur Hälfte gefaltet (z.B. Protein: in nativer Konformation) und zur Hälfte entfaltet (z.B. Protein: unstrukturiert, denaturierte Form) vorliegt. Dabei kann die Änderung der Intensität der Fluoreszenz z.B. in Abhängigkeit von der Temperatur oder der Zugabe eines Denaturants oder Cofaktors/Liganden bestimmt werden und/oder ein zeitlicher Verlauf aufgenommen werden.

Im Falle der Untersuchung von Proteinen kann beispielsweise die Tryptophan-Fluoreszenz bei einer Wellenlänge von 330 nm +/- 10nm und 350 nm +/- 10nm gleichzeitig aber spektral getrennt gemessen werden. Der Quotient der Fluoreszenzintensität bei 350 nm zur Fluoreszenzintensität bei 330 nm (F350/F330) ist eine bevorzugte Messgröße, da er von internen Struktur-/Konformationsänderungen der Partikel abhängt. Beispielsweise verschiebt sich das Fluoreszenz Emissionsmaximum von Tryptophan von kurzwelligen Wellenlängen (z.B. 330 nm +/- 10 nm) zu langwelligen Wellenlängen (z.B. 350 nm +/- 10 nm), wenn das Tryptophan durch die Entfaltung eines Proteins aus einer hydrophoben Umgebung, z.B. eines Proteininneren, in eine hydrophile Umgebung gelangt, beispielsweise Wasser. Beispielsweise kann der Schmelzpunkt aus dem Maximum der ersten Ableitung der F350/F330-Kurve bestimmt werden.

**Extinktions- / Wegstreuungs-Messung**

Partikel in Lösungen sind in der Lage, eingestrahltes Licht zu streuen. Unter Streuung versteht man in der Physik allgemein die Ablenkung eines Objekts durch Wechselwirkung mit einem lokalen anderen Objekt (Streuzentrum). Lichtstreuung an den Partikeln ist somit die Ablenkung des eingestrahlten (Anregungs-) Lichts durch Wechselwirkung mit einem zu untersuchenden Partikel. Der Streuwinkel θ ist als der Winkel definiert, um den das gestreute Licht abgelenkt wird. Erfindungsgemäß wird von Streuung gesprochen, wenn das Licht tatsächlich abgelenkt wird, vorzugsweise mehr als 1°, vorzugsweise mehr als 2°, 3°, 4° und vorzugsweise weniger als 179°, 178°, 177°, 176° gemessen vom Stahlverlauf des eingestrahlten (Anregungs-) Lichts.

Man unterscheidet unterschiedliche Streuarten, wie beispielhaft Rayleigh-Streuung (Partikelgrößen ~1/10 der Lichtwellenlänge, d.h. Partikelgrößen die klein sind im Vergleich zur Lichtwellenlänge) und Mie-Streuung (Partikelgrößen im Größenbereich der Lichtwellenlänge und größer). Das Ausmaß der Streuung in einer Lösung hängt von der Partikelgröße und -anzahl ab. Da die Streuintensität der Rayleigh-Streuung mit der inversen 4.Potenz von der Wellenlänge abhängt, ist sie in kurzen Wellenlängenbereichen, beispielhaft 300-400 nm, stärker ausgeprägt als in langwelligeren Wellenlängenbereichen. Das Ausmaß der Streuung kann durch Extinktionsmessung quantifiziert werden, indem die Intensität des eingestrahlten Lichts mit der Intensität des transmittierten Lichts verglichen wird. Die Differenz entspricht der Menge an weggestreutem Licht, und dient somit als Maß für die Partikelbildung bzw. Partikel-Aggregation.

Für Biomoleküle, beispielhaft Proteine, ist die Detektion der Extinktion bei einer Wellenlänge größer als 300nm vorteilhaft. Insbesondere ist die Detektion der Exktinktion zwischen 300 und 400 nm vorteilhaft, und bei etwa 385 nm besonders vorteilhaft, da hier im Wesentlichen kein Licht mehr absorbiert wird (Absorptionsmaximum von Proteinen liegt bei ca. 280 nm), die Streuung aufgrund der Wellenlängenabhängigkeit der Rayleigh-Streuung aber sehr groß ist. Beispielsweise ist die Verwendung von Licht bei 385nm vorteilhaft, da geeignete LEDs auf dem Markt bei dieser Wellenlänge leistungsstärker sind als LEDs mit deutlich kurzwelligerer Wellenlänge. Insbesondere ist eine starke Lichtleistung vorteilhaft, um viele Photonen zu detektieren. So ist beispielsweise die Messung der Extinktion häufig durch Photonenrauschen limitiert. Das Signal-Rausch-Verhältnis des Photonenrauschens folgt einer Poisson Statistik, d.h. es wird mit Wurzel (Anzahl der Photonen) besser.

Zudem bietet die oben genannte Auswahl der Wellenlänge für die Extinktion auch noch weitere Vorteile. Da das Licht von den Partikeln nicht absorbiert wird, werden die Partikel auch nicht zerstört, sodass eine "starke" Lichtleistung in diesem Wellenlängenbereich verwendet werden kann. Die Lichtleistung der LED für die Extinktionsmessung ist vorzugsweise im Bereich von über 100 μW, vorzugsweise im Bereich größer als 1mW. Vorzugsweise ist die Lichtleistung der LED für die Extinktionsmessung im Bereich 0,1mW bis 5mW.

Für die Messung der Extinktion ist ein geringes Rauschen des Signals und ein geringer Drift der Anregungslichtquelle von Vorteil. LEDs können mit geeigneten LED-Steuerungen sehr stabil und rauscharm betrieben werden und sind daher vorteilhaft für Extinktionsmessungen.

Da Biomoleküle, beispielsweise Proteine, deutlich kleiner sind als die vorteilhaften Wellenlängenbereiche, kann Rayleighstreuung angenommen werden. Da die Rayleighstreuung von der 6. Potenz des Partikeldurchmessers abhängt, führen Größenänderungen der Partikel, beispielsweise hervorgerufen durch eine Aggregation der Partikel, zu einer starken Änderung der Streuung. Da die Streuung an Partikeln in alle Raumrichtungen stattfindet, wird erfindungsgemäß vorgeschlagen, die Streuung bzw. ein Maß der Streuung über die Extinktion zu quantifizieren, da hier eine streuwinkelunabhängige Quantifizierung der gesamten Streuung möglich ist, im Gegensatz zu konventionellen Lichtstreumessungen, bei denen Streulicht nur in einem kleinen Winkelbereich detektiert wird. Extinktionsmessungen sind außerdem weniger sensitiv auf Messartefakte, beispielhaft Reflektionen an Grenzflächen und Verunreinigungen wie z.B. Staubpartikel.

Bevorzugte Wellenlängen bzw. Wellenlängenbereiche für Extionktionsmessungen sind beispielsweise aus der Figur 16 ableitbar, in der ein Absorptionsspektrum für Proteine dargestellt ist. Beispielsweise kann aus diesem Spektrum abgeleitet werden, dass Wellenlängen größer als 280nm, vorzugsweise größer als 300nm besonders bevorzugt sind.

## Probenbehälter

Erfindungsgemäß werden Proben untersucht, die sich in Form von Flüssigkeiten bzw. Fluiden in Behältern bzw. Probenbehältern befinden. Prinzipiell ist das erfindungsgemäße Verfahren nicht auf eine bestimmte Art und Form von Probenbehältern beschränkt. Vorzugsweise werden als Probenbehälter jedoch Kapillaren verwendet, was mehrere Vorteile hat. Beispielsweise führt die Verwendung von dünnen Kapillaren zu einem geringen Materialverbrauch aufgrund des kleinen Volumens. Zudem bieten dünne Kapillare große Kapillarkräfte, um die Flüssigkeit passiv, alleine durch die Kapillarkräfte einzusaugen. Selbst hoch viskose Flüssigkeiten können durch die Kapillarkräfte in Kapillaren gesaugt werden. Es ist beispielsweise auch möglich, die einzusaugende Probe auf den Kopf zu stellen, so dass auch die Gravitationskräfte in Richtung der Kapillarkräfte wirken und so das Befüllen unterstützen. Die Verwendung von Einweg-Kapillaren verhindert Kreuz-Kontamination zwischen den einzelnen Proben. Dünne Kapillare bedeutet, dass die optische Weglänge durch die Kapillare gering ist. Das ist vorteilhaft, um auch sehr hoch konzentrierte Lösungen (hohe Konzentration an Partikeln) messen zu können. Gemäß der vorliegenden Erfindung können beispielsweise einzelne Kapillaren verwendet werden oder Kapillaren in Trägern. So ist es beispielsweise möglich, einen Träger mit mehreren Kapillaren auf der reflektierenden Oberfläche zu plazieren, wobei die mehreren Kapillaren vorzugsweise in Kontakt mit der Oberfläche sind, ohne dass die Kapillaren aus dem Träger entfernt werden müssen. Mit anderen Worten, die Kapillaren können durch den Kontakt mit der Oberfläche über Kontakttemperierung temperiert werden, während die Kapillaren im Träger verbleiben.

Bevorzugte Träger mit Kapillaren sind beispielsweise in der EP 2 848 310 beschrieben. Insbesondere bezieht sich die EP 2 848 310 auf einen Träger für mehrere Kapillaren, mit dem eine gleichzeitige Befüllung mehrerer Kapillaren aus einer Mikrotiterplatte ermöglicht wird. Zudem betrifft die EP 2 848 310 auch eine Vorrichtungen und ein Verfahren für Befüllung, Transport und Messung von Flüssigkeiten mit Volumina im Mikroliterbereich. Gemäß einer bevorzugten Ausführungsform können 24 Kapillaren in einem Träger angeordnet werden.

Die flüssige Probe befindet sich während der Messung vorzugsweise in einem statischen, d.h., nicht fließenden Zustand innerhalb der Kapillaren. Vorzugsweise gibt es während der Messung keine Strömungen innerhalb der Kapillaren die über die natürliche Temperaturbewegung und/oder etwaige verdunstungsinduzierte Bewegungen in der Flüssigkeit hinaus gehen.

Die Kapillaren können aus Glas und/oder einem Polymer und/oder zumindest einem der Elemente aus Borosilikatglas, Borosilikat-3.3- Glas (zum Beispiel Duranglas), Quarzglas wie Suprasil-, Infrasil-, synthetisch hergestelltes Quarzglas, Kalknatronglas, Bk-7-, ASTM Type 1 Klasse A Glas, ASTM Type 1 Klasse B Glas hergestellt sein. Die Polymere können enthalten: PTFE, PMMA, Zeonor™, Zeonex™, Teflon AF, PC, PE, PET, PPS, PVDF, PFA, FEP und/oder Acrylglas.

Insbesondere ist es bevorzugt, dass zumindest ein Bereich der Kapillaren für Licht der Wellenlänge von 200nm bis 1000nm, vorzugsweise von 250nm bis 900nm transparent ist. Insbesondere bevorzugt, aber nicht darauf beschränkt, ist dieser Bereich der Kapillare auch für Licht der folgenden Wellenlängenbereiche transparent: von 940nm bis 1040nm (vorzugsweise 980nm +/-10nm), von 1150nm bis 1210nm, von 1280nm bis 1600nm (vorzugsweise 1450nm +/-20nm und/oder 1480nm +/-20nm und/oder 1550nm +/-20nm), von 1900nm bis 2000nm (vorzugsweise 1930nm +/-20nm). Der Fachmann versteht, dass der/die transparente(n) Bereich(e) sich auch über die gesamte Kapillare erstrecken kann/können. Mit anderen Worten, die Kapillaren können transparent sein und sind vorzugsweise einstückig aus einem der oben genannten Materialien hergestellt.

Vorzugsweise haben die verwendeten Kapillaren einen Innendurchmesser von 0,1mm bis 0,8mm, bevorzugt 0,2mm bis 0,6mm, mehr bevorzugt 0,5mm. Der Außendurchmesser bevorzugter Kapillaren liegt vorzugsweise zwischen 0,2mm bis 1,0mm, bevorzugt 0,3mm bis 0,65mm.

Die Geometrie der Kapillaren ist nicht auf eine bestimmte Form beschränkt. Vorzugsweise werden röhrenförmige Kapillaren mit einem runden Querschnitt oder einem ovalen Querschnitt verwendet. Es ist jedoch auch möglich Kapillaren mit einem anderen Querschnitt zu verwenden, beispielsweise dreieckig, viereckig, fünf- oder mehreckig. Zudem können auch Kapillaren verwendet werden bei denen der Durchmesser und/oder der Querschnitt über die Länge der Kapillaren nicht konstant oder konstant ist.

## Siliziumfläche

Erfindungsgemäß liegen die Probenbehälter auf einer Siliziumfläche. Vorzugsweise werden als Probenbehälter Kapillaren verwendet, die über einer Siliziumfläche angeordnet sind. Die Siliziumfläche dient vorzugsweise als Spiegelfläche bzw. Fläche für die Reflektion des Anregungslichts. Zudem können erfindungsgemäß die Probenbehälter bzw. Kapillaren in direkten Kontakt mit der Siliziumfläche gebracht werden, sodass ein direkter Kontaktwärmeaustauch zwischen Probenbehälter/Kapillare und Silizium erreicht wird. Silizium bietet eine Reihe von Eigenschaften, die für die vorliegende Erfindung besonders vorteilhaft sind.

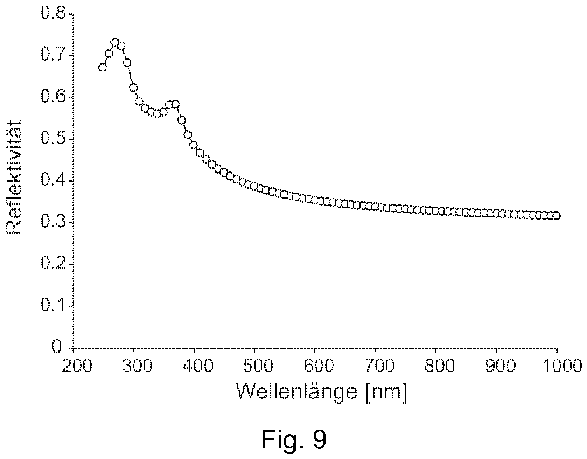

Silizium hat im bevorzugten Wellenlängenbereich keine Autofluoreszenz. Silizium hat im erfindungsgemäß bevorzugten Wellenlängenbereich eine hohe Reflexion (siehe beispielsweise Fig. 9). Zudem hat Silizium eine hohe thermische Leitfähigkeit, was besonders vorteilhaft ist für die schnelle und homogene Temperierung von einer Vielzahl an Kapillaren. Diese drei Eigenschaften sind für die erfindungsgemäße Vorrichtung bzw. das erfindungsgemäße Verfahren besonders vorteilhaft.

Weitere Vorteile von Silizium sind beispielsweise die chemische Resistenz, die einfache Verfügbarkeit des Materials und die einfache Verarbeitung, die es zudem erlaubt, sehr glatte bzw. sehr präzise Formen/Flächen zu bilden.

Die Erfindung ist jedoch nicht auf die Verwendung auf Silizium beschränkt. So können anstelle von Silizium auch andere Materialien für die Spiegelfläche und/oder Temperierung verwendet werden. Generell eignen sich Stoffe die im bevorzugten Wellenlängen Messbereich eine geringe oder keine Autofluoreszenz zeigen und vorzugsweise gleichzeitig eine Reflexion des eingestrahlten Lichtes, beispielsweise >10% Reflexion zeigen. Erfindungsgemäß kann beispielsweise auch eine Quarzschicht, bzw. ein Quarzplättchen verwendet werden, das vorzugsweise mit einer reflektierenden Beschichtung, beispielsweise einer interferometrischen Beschichtung versehen ist.

Die vorliegende Erfindung bietet eine Reihe von Vorteilen hinsichtlich Effizienz, Schnelligkeit und Kosten für die Durchführung mehrerer Messungen. Die Kombination aus dünnen Kapillaren, die vorzugsweise auf Silizium aufliegen und vorzugsweise kontinuierlich relativ zu einer einzigen Optik verschoben werden, zusammen mit der Messung der intrinsischen Fluoreszenz (Fluoreszenz, Phosphoreszenz, Lumineszenz) und der Messung der Wegstreuung (Extinktion) ist bevorzugt und besonders vorteilhaft. Insbesondere ist aufgrund der Kombination der sehr guten Wärmeleiteigenschaften, mit dessen Eigenschaft Licht der benutzten Wellenlänge zu reflektieren, Silizium ein bevorzugtes Material. Auch die schnelle und genaue Detektion von Extinktion durch Abfahren einer Vielzahl von Proben ohne Verweildauer auf einzelnen Kapillaren, erhöht die Messgeschwindigkeit und Datenpunktdichte im Vergleich zu konventionellen Methoden drastisch.

Das erfindungsgemäße Verfahren und die erfindungsgemäße Vorrichtung unterscheiden sich grundlegend vom Stand der Technik. Insbesondere werden erfindungsgemäß Komponenten in einer Art und Weise kombiniert, wie sie ein Fachmann auf dem Gebiet der Lichtstreuung basierend auf der Lehre des Standes der Technik nicht verwenden würde. Zudem unterscheidet sich die erfindungsgemäße Messung auch von bekannten Verfahren, wie sie ein Fachmann auf dem Gebiet der Absorptionsmessungen durchführen würde. Prinzipiell gibt es zwar Gemeinsamkeiten zwischen dem optischen System für eine Absorptions-Messung und einer erfindungsgemäßen Vorrichtung. Erfindungsgemäß wird jedoch die Wellenlänge für die Extinktionsmessung gezielt so ausgewählt, so dass sie von der Probe nicht absorbiert wird. Damit wird erfindungsgemäß erreicht, dass die größenabhängige Wegstreuung des Lichts gemessen werden kann.

Aus dem Stand der Technik ist beispielsweise eine Vorrichtung bekannt, die unter dem Namen UNit™ von unCHAINED LABS vertrieben wird. Bei dieser Vorrichtung müssen Mikroküvetten individuell angefahren werden und für die Messung müssen die Mikroküvetten zur Messoptik genau ausgerichtet werden. Erfindungsgemäß bewegen sich die Kapillaren ständig / kontinuierlich ohne für die Messung anzuhalten; die Kapillaren werden "durchgescannt". Dadurch wird erfindungsgemäße eine viel robustere, wirtschaftlichere Ausführung und vor allem eine sehr viel höhere Datendichte erreicht.

Durch die Aufnahme ganzer Spektren nach dem Stand der Technik beträgt die Messdauer pro angefahrener Mikroküvette mehrere Sekunden. Somit dauert die Messung von beispielsweise 48 Proben bei einer einzigen Temperatur bereits mehrere Minuten. Eine Heizrate mit der üblichen 1°C/min führt somit zu einer geringen Datenpunktdichte. Erfindungsgemäß ist es bereits ausreichend, dass lediglich zwei diskrete Wellenlängen detektiert (Extinktion und Fluoreszenz) werden, wobei die Kapillaren für je < 50 ms im Vorbeifahren belichtet werden können, so dass man erfindungsgemäß eine um Größenordnungen höhere Datenpunktdichte erhält.

Im Stand der Technik wird wie üblich eine statische Lichtstreuung gemessen, d.h. das Anregungslicht wird so blockiert, um wirklich nur einen Teil des Lichtes das gestreut wird, zu messen. Erfindungsgemäß wird jedoch der transmittierte Anteil bzw. der rückreflektierte Teil gemessen, d.h. das Licht bzw. der Anteil des eingestrahlten Lichts, der nicht gestreut wird.

Außerdem setzt die Messung der Lichtstreuung aus dem Stand der Technik ein genaues Ansteuern der Proben voraus, was aufwendige Justage und regelmäßige Wartungen erfordert. Dies hat zudem eine schlechte Reproduzierbarkeit zur Folge, da schon kleine Fehler bei der Ansteuerung einzelner Proben zu Schwankungen im Lichtstreusignal führen können.

Erfindungsgemäß wird das Extinktionslicht gemessen, nachdem das Licht aufgrund der Reflexion 2x durch die Kapillare hindurchläuft. Bei hoher Konzentration an Partikeln und bei einer langen Weglänge (z.B. 1cm) würde kein Licht mehr durch die Kapillare zurückkommen. Deshalb sind erfindungsgemäß dünne Kapillaren mit einem Innendurchmesser von beispielsweise 0,5mm bevorzugt. Die Lösungen / Verfahren / Geräte die derzeit auf dem Markt sind, haben Probleme hoch konzentrierte Lösungen, beispielsweise hochkonzentrierte Antikörper (z.B. mit 150 mg/ml Antikörper in wässriger Lösung), zu handhaben und zu messen. Zum einen weil sie hochviskose Flüssigkeiten nicht in ihre verwendeten Probenkammern füllen können, zum anderen weil ihre optischen Weglängen zu lang sind. Diese hochkonzentrierten Lösungen sind für die Pharmaindustrie, insbesondere die Formulierungsmessung, jedoch sehr interessant.

Die Verwendung von dünnen Kapillaren ermöglicht einen großen dynamischen Messbereich, da die Messungen hochsensitiv sind (geringe/keine Autofluoreszenz des Kapillarmaterials und des Siliziums im Falle der Fluoreszenzdetektion, große Transmission der dünnwandigen Kapillaren und gute Reflektionseigenschaften/Homogenität des Siliziums im Falle der Extinktionsdetektion), und gleichzeitig die Messung hochkonzentrierter Lösungen zulassen (dünne optische Schichtdicke vorteilhaft bei Extinktionsmessungen von hochkonzentrierten Lösungen). Das erfindungsgemäße Verfahren ist robust gegenüber Innerfilter-Effekte da jede einzelne Probe auf sich selbst referenziert wird. Hierdurch können große Stoffmengenkonzentrationsbereiche, beispielhaft von 50 mg/ml Protein bis 5 μg/ml Protein, in einer einzigen Messung analysiert werden.

**Eigenschaft kontinuierliches hin- und herfahren der Kapillaren unter der Optik:**

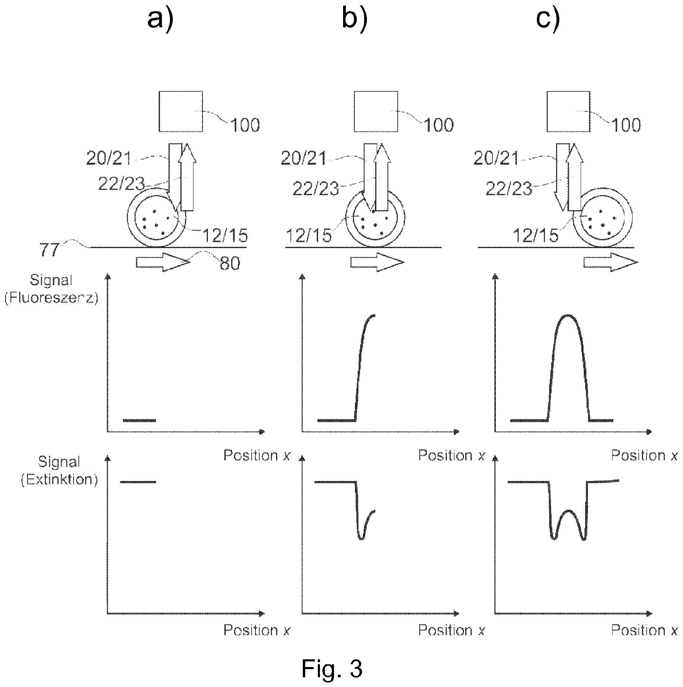

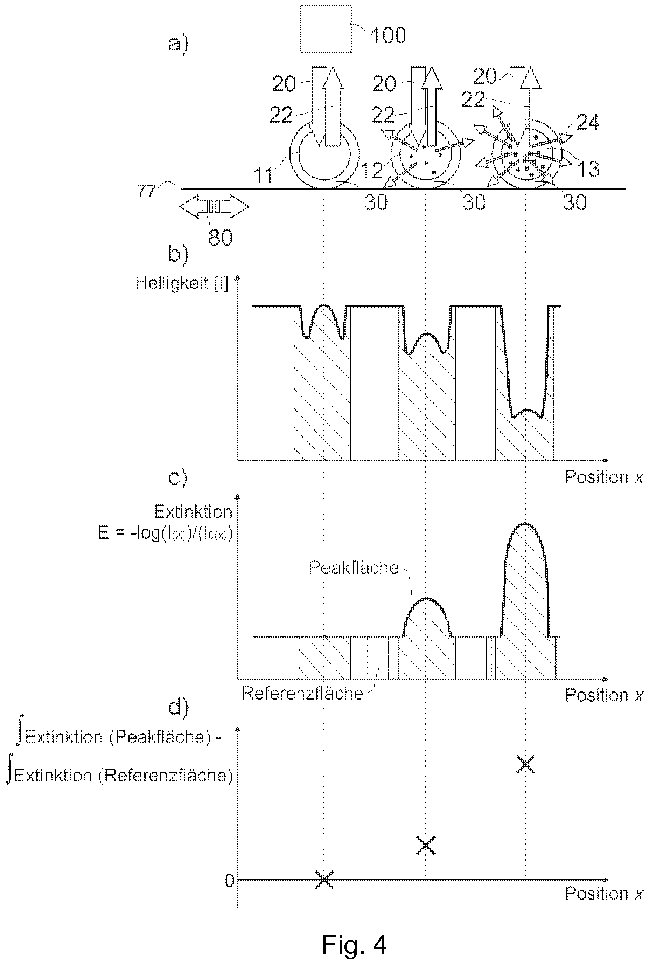

Das bevorzugte kontinuierliche relative Verschieben der Kapillaren zur Optik während einer Messung (siehe Figuren 3 und 4) bietet weitere Vorteile hinsichtlich Effizienz und Messgenauigkeit. Erfindungsgemäß können mehrere Proben parallel gemessen werden, beispielsweise indem alle Proben gleichzeitig auf die gleiche Temperatur temperiert werden. Das erfindungsgemäße Verfahren benötigt keine lange Verweildauer auf den einzelnen Kapillaren; auch ein gezieltes Anfahren eines speziellen Messpunktes auf der Kapillare ist nicht nötig, wodurch das Verfahren sehr robust und sehr schnell ist.

Erfindungsgemäß kann zudem die Symmetrie der Kapillare ausgenutzt werden, da vorzugsweise senkrecht zur Längsachse der Kapillare gemessen wird. Zudem sind runde bzw. zylindrische Kapillaren (runder Querschnitt) vorteilhaft, da solche Kapillaren nicht nur günstig, sondern auch in sehr guter Qualität und mit hoher Genauigkeit herstellbar sind.

Durch den erfindungsgemäßen schnellen Scanvorgang sind sehr hohe Datenpunktdichten erreichbar, was sich vorteilhaft auf die Datenauswertung auswirkt. Im Folgenden werden einige dieser Vorteile anhand eines Beispiels durchgerechnet.

Beispielsweise sind 48 einzelne Kapillaren mit Innendurchmesser 0,5mm und Außendurchmesser 0,65mm im Abstand von 2,25mm (Mitte Kapillare zu Mitte Kapillare) liegend auf dem temperierten Silizium aufgebracht. Dieser ganze Temperierkörper mit den Kapillaren wird beispielsweise mittels einer Linearachse, die beispielsweise mit einem Schrittmotor angetrieben wird, kontinuierlich unter einer ortsfest montierten Optik hin und her verfahren.

Beispielsweise werden der Temperierkörper, und damit die Kapillaren, mit einer Geschwindigkeit von beispielsweise 45 mm/s unter der Optik verfahren. Bei dieser Geschwindigkeit werden alle 48 Kapillaren mit Abstand 2,25mm innerhalb von ca. 3 Sekunden abgefahren. Speziell wird durch das hin und her Fahren jede Kapillare im Mittel alle 3 Sekunden ("Mittel" weil z.B. die äußersten beiden Kapillaren durch das Umkehren der Fahrtrichtung 2 mal praktisch instantan nacheinander gemessen werden und es dann 3 Sekunden (wegfahren) + 3 Sekunden (zurückkommen) = 6 Sekunden dauert bis die Kapillare wieder genau unter der Optik ist) gemessen.

In einer beispielhaften Anwendung wird die Temperatur des Temperierkörpers, und damit die Temperatur der Kapillaren während des kontinuierlichen hin und her Fahrens, kontinuierlich mit einer Rate von 1°C pro Minute erhöht. So erreicht man bei der Temperaturrampe von 1°C pro Minute eine Datendichte von 20 Messpunkten pro Kapillare und pro Minute was dann einer Temperaturauflösung von im Mittel 0,05°C entspricht. Halbiert man die Erhöhungsgeschwindigkeit der Temperatur von 1°C pro Minute auf 0,5°C pro Minute bei gleichbleibender Anzahl an Kapillaren und gleichbleibender Verfahrgeschwindigkeit, so verdoppelt sich die Temperaturauflösung von 0,05°C (Fall 1°C pro Minute) auf 0,025°C (Fall 0,5°C pro Minute).

Da kontinuierlich über den gesamten Durchmesser der Kapillaren gescannt d.h. gemessen wird ist die erfindungsgemäße Methode robuster gegenüber lokalen Verunreinigungen (z.B. Staubpartikel, Luftbläschen, insbesondere Verunreinigungen die kleiner als der Durchmesser der Kapillare sind) als bei gewöhnlichen Verfahren aus dem Stand der Technik, bei denen nur an einem einzigen Punkt der Kapillare gemessen wird (siehe beispielsweise UNit™ von unCHAINED LABS). Insbesondere können im Stand der Technik bereits kleiner lokale Verunreinigungen zu einem Messartefakt führen und zu einer Verwerfung der Messung führen.

Ein weiterer vorteilhafter Aspekt des erfindungsgemäßen Abscannens der Kapillaren besteht auch darin, dass bedingt durch das Überstreichen der runden Kapillaren mit dem "Messstrahl" praktisch automatisch verschiedene Schichtdicken gemessen werden. So zeigt beispielsweise die Fig. 3, dass in der Mitte der Kapillare die maximale Probendicke/Schichtdicke vorhanden ist. An den Rändern ist symmetrisch eine geringere Schichtdicke der Probenflüssigkeit. Das ist beispielsweise vorteilhaft für sehr hochkonzentrierte Lösungen bei denen die Wegstreuung so hoch ist, dass in der Mitte der Kapillare (größte Schichtdicke) kein Signal mehr durchkommt (das gesamte Licht wird weggestreut). Wenn aber kein Signal mehr kommt, kann man keine Änderungen des Signals mehr messen. Da erfindungsgemäß über den gesamten Durchmesser der Kapillaren gescannt wird, erhält man Messwerte >0 in den Randbereichen in denen der reflektierter Lichtstrahl eine kürzere Weglänge durch die Kapillare zurücklegen musste. Das ist ein praktischer Vorteil da man so einen größeren Konzentrationsbereich an Proben in der Lösung durchmessen kann.

## Optik zur Messung der Fluoreszenz und Extinktion/Wegstreuung

Ein weitere Vorteil der vorliegenden Erfindung ist in der einfacheren konstruierten Optik zur Messung von Fluoreszenz und Extinktion zu sehen. Vorzugsweise kann für beide Messungen kann eine gemeinsame Optik für beide Messungen verwendet werden. Die Vorteile der erfindungsgemäßen (gemeinsamen) Optik sind beispielsweise im Bereich Justage, Positionierung, Materialverbrauch zu sehen, verglichen mit den separaten Optiken aus dem Stand der Technik. Zudem ist die erfindungsgemäße gemeinsame Optik auch noch platzsparender.

Erfindungsgemäß können die Floreszenz und Extinktionsmessungen nacheinander, quasi gleichzeitig oder gleichzeitig erfolgen. Gleichzeitigkeit der Messung bedeutet: intra Partikel (= intramolekulare) Vorgänge können mittels Fluoreszenz gleichzeitig mit der Messung der Größenänderung der Partikel (= intermolekular) mittels "Wegstreuung"/Extinktion durchgeführt werden. Man erhält so eine direkte Korrelation beider Vorgänge. Man kann so erkennen, ob Denaturierung (Fluoreszenz) und Aggregation (Extinktion) gleichzeitig bzw. bei gleicher Temperatur beginnen oder ob ein Vorgang vor dem anderen beginnt. Das führt auch dazu, dass die Messung an sich robuster ist.

Die Gleichzeitigkeit der Messung führt zudem zu einer höheren bzw. hohe Datendichte: pro Zeiteinheit können doppelt so viele Daten gemessen werden, als wenn Extinktion und Fluoreszenz getrennt gemessen werden. Dadurch erhöht sich die Präzision der Messung und der Schmelzpunkt eines Proteins und die Temperatur bei der die Aggregation des Proteins beginnt können genauer bestimmt werden.

Die erfindungsgemäße Ausführung der Extinktionsmessung ("Wegstreuungs"-Messung) ist robuster gegenüber Verschmutzungen, Verunreinigungen, Luftbläschen auf und in der Kapillare als das statische Streulicht Messausführungen sind.

Bevorzugte Stoffmengenkonzentrationen von Partikeln, beispielsweise Proteine wie Antikörper, Enzyme, Peptide, liegen zwischen 0.001 und 500 mg/ml. Vorteilhafte Konzentrationen liegen zwischen 0.1 und 100 mg/ml.

Die erfindungsgemäße Ausführung und das erfindungsgemäße Verfahren erlauben es in einem einzigen Experiment viele verschiedene Konzentrationen gleichzeitig zu messen. D.h. mit ein und derselben Mess-Einstellung können Konzentrationen die beispielsweise um einen Faktor 1000 auseinander liegen gleichzeitig gemessen werden.

Mit dem erfindungsgemäßen Systeme und Verfahren sind Messungen der thermischen Stabilität von Partikeln, der chemischen Stabilität von Partikeln sowie die zeitliche Stabilität der Partikel möglich. Im Folgenden werden Beispiele für Messungen der Stabilität konkreter beschrieben.

## Thermische Stabilität

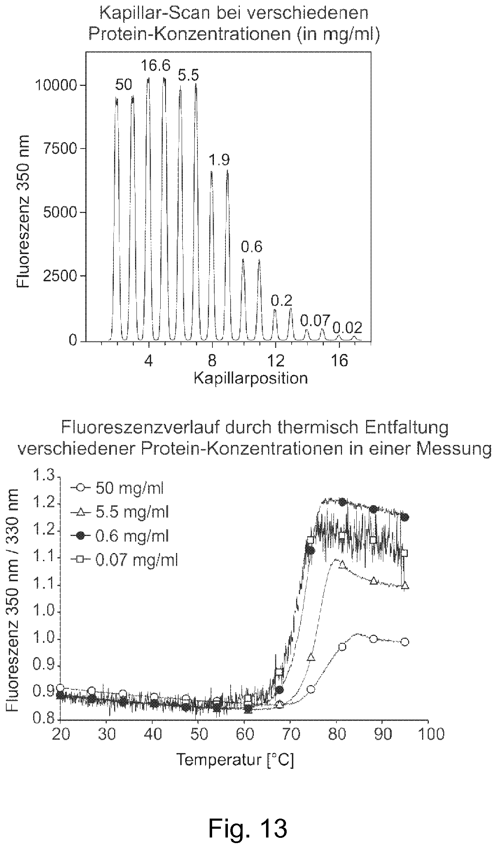

Bei der Messung der thermischen Stabilität werden die Partikel vorzugsweise in wässriger Lösung bzw. flüssiger Phase in den Kapillaren auf dem Temperierkörper mit Silizium vorgelegt und vorzugsweise kontinuierlich die intrinsische Fluoreszenz und (vorzugsweise gleichzeitig) die Wegstreuung/Extinktion gemessen, während die Temperatur der Kapillaren von einem niedrigen Wert, beispielsweise 15°C, bis zu einem hohen Wert, beispielsweise 95°C, erhöht wird (siehe Fig. 13). Beispielsweise können auch Temperaturen von -20°C bis +130°C und/oder Teilbereiche davon verwendet werden.

Zunächst wird die Silizium-Oberfläche mit einem Tuch und absolutem Ethanol durch mehrmaliges Wischen gereinigt. Anschließend werden mindestens 10 $\mu$l der zu analysierende Proben vorbereitet, beispielhaft Antikörper Lösungen in unterschiedlichen Stoffmengenkonzentrationen, beispielhaft zwischen 5 mg/ml und 0.3 mg/ml, oder unterschiedliche Biomoleküle, oder identische Biomoleküle in unterschiedlichen Puffern. Je 10 μl dieser Lösungen werden dann durch die Ausnutzung von Kapillarkräften durch Eintauchen der Kapillaren in die Lösungen in die Kapillaren gefüllt. Befüllte Kapillaren werden dann auf einen Kapillarträger überführt und anschließend mittels eines Deckels auf der Siliziumoberfläche angepresst. Anhand eines durchgeführten "Discovery Scans", bei dem sowohl die Extinktion als auch die Fluoreszenz bei 330 und 350nm Emissionswellenlänge aller Kapillaren innerhalb von 3-5 Sekunden bei einer Temperatur von 20°C erfasst wird, werden die Lichtintensitäten angepasst, was manuell oder automatisch geschehen kann, um Überbelichtung der Detektoren zu vermeiden. Anschließend werden der zu messende Temperaturbereich, beispielhaft 20°C - 95°C, und die Temperaturrampe, beispielhaft 1°C/min, festgelegt. Letztere kann beispielsweise zwischen 0.1°C/min und 100°C/min variiert werden. Nach Festlegung dieser Parameter wird die Messung gestartet und die Temperaturabhängigkeit der Proben-Extinktion und -Fluoreszenz zeitgleich gemessen und dargestellt. Nach Beendigung der Messung wird die Temperatur automatisch auf den Anfangswert zurückgesetzt.

Die Analyse der thermischen Entfaltungskurven erfolgt beispielsweise über die Ermittlung der spezifischen Entfaltungstemperatur (die Temperatur bei der 50% der Partikel entfaltet sind), was beispielhaft durch Identifikation der Wendepunkte durch Analyse der ersten oder zweiten Ableitung der Rohdaten, oder durch anderweitige mathematische Prozesse geschehen kann. Die Analyse der Partikelbildung durch Extinktionsmessung erfolgt vorzugsweise mathematisch durch Ermittlung der Temperatur bei welcher die Aggregation einsetzt, und durch die Ermittlung der maximalen Extinktion.

Beispielsweise kann mittels einer thermischen Stabilitätsmessung auch die Reversibilität oder Irreversibilität einer Entfaltung eines Partikels bestimmt werden. Dies kann beispielsweise durchgeführt werden indem man zuerst die Temperatur von 20°C auf 95°C mit einer Temperatur-Rampe von 1°C pro Minute erhöht und anschließend die Temperatur von 95°C wieder mit der gleichen oder einer anderen Temperatur Rampe auf 20°C erniedrigt. Ist eine Entfaltung reversibel, so erreicht beispielsweise das Fluoreszenz Verhältnis 350nm zu 330nm nach der Durchführung des Aufheizenz und Abkühlens wieder das Ausgangsniveau / den gleichen Wert das/den es für diesen Prozess hatte. Bei gleichzeitiger erfindungsgemäßen Messung der Aggregation kann herausgefunden werden, ob die Aggregation zu einer Irreversibilität der Entfaltung führt. Weist beispielsweise ein Antikörper im Fluoreszenzsignal verschiedene thermische Entfaltungsvorgänge auf, beispielsweise mit Schmelztemperaturen von 60°C und 72°C und weist er gleichzeitig bei der Extinktion eine Aggregation bei 75°C auf, so kann man beispielsweise in einem ersten Experiment bis 60°C heizen und dann wieder abkühlen und in einem zweiten Experiment über 75°C heizen, also über die Aggregations-Temperatur hinaus, und wieder abkühlen. Zeigt das erste Experimente eine reversible Entfaltung und das zweite Experimente eine irreversible Entfaltung, so kann man daraus schließen, dass die Aggregation zu einer irreversiblen Entfaltung führt, bzw. eine Rückfaltung in den nativen Zustand verhindert.

**Chemische Stabilität:**

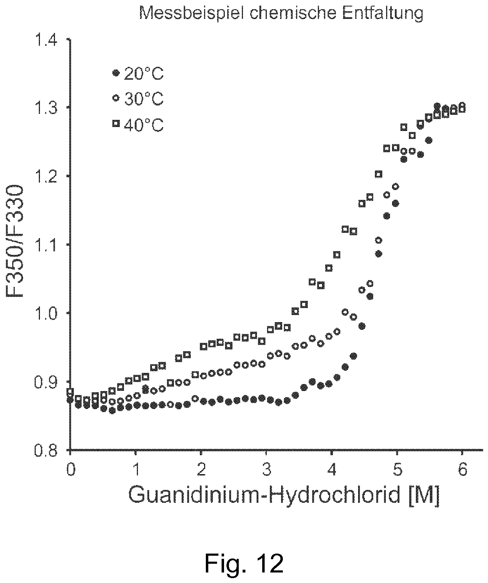

Bei der Messung der chemischen Stabilität werden die Partikel in wässrigen Lösungen mit aufsteigenden Konzentrationen an Denaturantien, beispielhaft chaotrope Salze wie Guanidinium-Hydrochlorid oder Harnstoff, versetzt, in Kapillaren gefüllt und auf dem Temperierkörper platziert. Das Ausmaß der Entfaltung der Partikel wird bei einer definierten Temperatur durch einmaliges Abfahren der Kapillaren und Detektion der Fluoreszenz ermittelt (siehe Fig. 12).

Anwendungsgebiete für chemische Entfaltung sind beispielhaft die Optimierung von Formulierungen von Proteinen, beispielhaft Antikörper und Enzyme, die thermodynamische Charakterisierung von Partikeln, sowie die Wirkstoffforschung.

**Zeitliche Stabilität**

Bei der Messung der zeitlichen Stabilität werden Partikel in wässriger Lösung in Kapillaren gefüllt und die Extinktion und Fluoreszenz bei konstanter Temperatur über einen definierten Zeitraum gemessen. Vorteilhaft bei Messungen > 3 Stunden ist das verschließen der Kapillarenden mit geeigneten Substanzen, beispielhaft Flüssigkunststoff, Klebstoff, Wax, Kit, oder mechanisch durch anpressen von geeigneten Materialien, beispielhaft Silikon, Gummi, Kunststoff, um Probenverlust durch Verdunstung zu unterbinden. Die Messung der zeitlichen Stabilität wird beispielhaft verwendet für die Charakterisierung von Partikeln, insbesondere Proteine und Wirkstoffe, und für die Optimierung von Formulierung für diese Partikel.

**Qualitätskontrolle**

Bei Messungen für die Qualitätskontrolle werden Partikellösungen auf ihre Reproduzierbarkeit hin getestet, oder es werden Lagerungs- und Stresstests durchgeführt. Bei letzterem werden beispielsweise Proteine Bedingungen ausgesetzt die potentiell negative Einfluss auf deren Faltung haben, beispielsweise erhöhte Temperatur, intensives Schüttlen/Rühren, Einfrier-Auftau Zyklen. Nach Durchführung der unterschiedlichen Prozeduren werden die Lösungen in Kapillaren gefüllt und die Fluoreszenz sowie Extinktion der Proben entweder mit einem einzigen Kapillar Scan, oder in einer Temperaturrampe, beispielsweise mit 1°C/min von 20°C bis 95°C, detektiert. Durch Vergleich mir einer unbehandelten Referenzprobe kann so der Anteil an entfaltetem und aggregiertem Protein ermittelt werden.

**Ligandenbindung**

Diese Messungen werden auch als "thermal shift assays" bezeichnet. Bei der Messung der Ligandenbindung werden Partikel, beispielsweise Enzyme, beispielsweise Kinasen, zusammen mit Liganden, beispielsweise Molekülfragmenten, in wässriger Lösung inkubiert. Bindet ein Ligand an einen Partikel so kann diese Ligandenbindung die Stabilität, beispielsweise die thermische Stabilität, des Partikels und/oder sein Aggregationsverhalten beeinflussen. Beispielsweise kann eine Ligandenbindung an einen Partikel dessen Schmelztemperatur, die Temperatur bei der 50% des Partikels in nativer Form und 50% in denaturierter Form vorliegen, erhöhen oder erniedrigen, d.h. den Partikel stabilisieren oder destabilisieren. Diese Verschiebung der Schmelztemperatur des Partikel-Ligand Komplexes gegenüber dem Partikel ohne Ligand kann als "delta T" gemessen werden und so die Bindung des Liganden an den Partikel detektiert werden. Die erfindungsgemäße Methode und Vorrichtungen ermöglichen es selbst kleinste Schmelztemperaturverschiebungen von delta T >= 0,2°C zuverlässig und reproduzierbar zu detektieren und zu quantifizieren. Verschiedene Liganden können dann beispielsweise anhand ihrer Schmelztemperaturverschiebung delta T sortiert und selektiert werden. Bei Anwendungen wie beispielsweise der Kristallografie von Proteinen werden Liganden gesucht die die Schmelztemperatur des Partikels bei einer Bindung zu besonders hohen Schmelztemperaturen verschieben und den Partikel somit stabilisieren.

Hierbei ist es von Vorteil nicht nur die thermische Stabilisierung mittels Fluoreszenzsignal zu messen, sondern auch eine mögliche Aggregation der Partikel, Liganden und/oder Partikel-Liganden Komplexe mittels der erfindungsgemäßen Extinktionsmessung. Das soll es ermöglich beispielsweise Liganden die zu einer thermischen Stabilisierung aber auch zu einer Aggregation auszusortieren.

**KURZE BESCHREIBUNG DER ZEICHNUNGEN**

Im Folgenden werden bevorzugte Ausführungsformen der vorliegenden Erfindung unter Bezugnahme auf die Figuren ausführlich beschrieben. Es zeigen:

Fig. 1      die Funktionsweise der erfindungsgemäßen Messung der Wegstreuung von Licht durch Messung der Abschwächung der Lichttransmission;

Fig. 2      die direkte Messung von Streulicht mit einem festen Streulicht Detektionswinkel gemäß dem Stand der Technik;

Fig. 3      die Entstehung von Fluoreszenz- und Extinktionssignalen durch Bewegung der Proben relativ zum optischen System;

Fig. 4      eine Ausführungsform zur Auswertung der Extinktionsmessung;

Fig. 5      eine Ausführungsform zur Auswertung der Fluoreszenzmessung;

Fig. 6      eine Ausführungsform zur gleichzeitigen Messung von Fluoreszenz und Extinktion;

Fig. 7a      eine Ausführungsform zur quasi-gleichzeitigen Messung von Fluoreszenz-Verhältnis und Extinktion mit eingezeichnetem Fluoreszenzstrahlengang;

Fig. 7b      die Ausführungsform von Fig. 7a, jedoch mit eingezeichnetem Extinktionsstrahlengang;

Fig. 8a      eine weitere Ausführungsform zur gleichzeitigen Messung von Fluoreszenz-Verhältnis und Extinktion mit eingezeichnetem Fluoreszenzstrahlengang;

Fig. 8b      die Ausführungsform von Fig. 8a, jedoch mit eingezeichnetem Extinktionsstrahlengang;

Fig. 9      die Reflektivität von Silizium;

Fig. 10    ein Messbeispiel zur gleichzeitigen Detektion der intramolekularen Entfaltung mittels Fluoreszenz und der intermolekularen Aggregation mittels Extinktion eines Antikörpers;

Fig. 11    ein Messbeispiel Extinktionsmessung der temperaturabhängigen Zunahme der Aggregation eines Antikörpers in unterschiedlichen Puffern;

Fig. 12    Messbeispiel zur Detektion der Proteinstabilität bei unterschiedlichen Temperaturen durch chemische Entfaltung;

Fig. 13    eine beispielhafte Messung zur Demonstration des dynamischen Bereichs der Fluoreszenzoptik unter Verwendung von unterschiedlichen Proteinkonzentrationen zwischen 50 mg/ml und 2 $\mu$g/ml;

Fig. 14    eine beispielhafte Messung für die Qualitätskontrolle von Proteinen durch Forced Degradation Tests;

Fig. 15    beispielhafte Messdaten zum Puffer Screening für optimale Lagerbedingungen eines Antikörpers;

Fig. 16    ein beispielhaftes Absorptionsspektrum eines Proteins; und

Fig. 17a,b    eine Draufsicht und Querschnittansicht eines erfindungsgemäßen Temperierkörpers.

## DETAILLIERTE BESCHREIBUNG BEVORZUGTER AUSFÜHRUNGSFORMEN

Fig. 2 zeigt eine übliche Art eines Verfahrens zur Messung von Partikeln durch eine statische Streulicht-Messung unter festem Winkel. Die zu untersuchende Probe 13 ist eine Flüssigkeit mit darin befindlichen stark streuenden bzw. stark aggregierenden Partikeln. Die Probenflüssigkeit befindet sich in einer Kapillare 30, die auf Fläche 77 gelagert ist. Für eine Extinktionsmessung wird Licht 20 von oben nach unten durch die Kapillare 30 in die Probenflüssigkeit eingestrahlt. Ein Teil des eingestrahlten Lichtes 20 wird direkt, d.h., im Wesentlichen entgegengesetzt zur Einstrahlrichtung, als reflektiertes Licht 22 zurückreflektiert. Zur Messung von Streulicht 24 befindet sich ein Streulicht-Detektor 200 in einem Winkel $\Phi$ zwischen einfallendem Lichtstrahl 20 und Probe und erfasst so direkt das in der Probe mit stark streuenden Partikeln 13 gestreute Licht 24.

Nachteile dieses Systems lassen sich wie folgt zusammenfassen. Der Beitrag zum Signal im Detektor 200 entsteht nur durch die Streuung in einen kleinen Winkelbereich um den Winkel $\Phi$. Durch die Messung unter einem schmalen Winkelbereich ist das System anfällig gegenüber ungewollten mechanischen Bewegungen, beispielsweise Bewegungen in vertikaler Richtung. In bestimmten Positionen der Kapillare 30 sind Reflexionen an den Kapillarwänden (siehe beispielsweise Strahl 25) in Richtung des Detektors 200 stärker als die Lichtstreuung an den zu untersuchenden Partikeln. Ein Fachmann auf dem Gebiet der Streulichtmessungen weiß, dass es wichtig ist, Reflexionen bzw. reflektierende Oberflächen 77 (z.B. Silizium) zu vermeiden, da von dort beispielsweise ein unerwünschter reflektierter Strahl 26 ebenfalls in den Detektor 200 eindringen kann. Dieser reflektierte Strahl 26, der in den Streulicht-Detektor 200 trifft, führt zu einer Verfälschung des Messsignals, da für Streulichtmessungen nur ein sehr schmaler Winkelbereich um den Winkel $\Phi$ gemäß der gängigen Lehrmeinung gemessen werden darf. Der Fachmann wird deshalb eine sehr aufwändige Optik bauen, um alles ungewollte Streulicht zu blockieren, was die Optik jedoch anfällig und teuer macht. Insbesondere wird ein Fachmann reflektierende Oberflächen vermeiden. Zudem erschwert die schräge Anordnung des Detektors 200 die Integration in bestehende Optiken mit vertikalem Strahlengang.

Fig.1 zeigt schematisch die Funktionsweise einer erfindungsgemäßen Messung. Vorzugsweise wird erfindungsgemäß nicht der weggestreute Anteil von Licht wie in Fig. 2 direkt gemessen, sondern durch Messung der Abschwächung der Lichttransmission, der sogenannten Extinktion. Mit anderen Worten, das Extinktionslicht ist nicht gestreutes Licht. Abhängig von der Auslegung der Optik wird Licht, das weniger als $\pm$ 10°, vorzugsweise weniger als $\pm$ 8°, 7°, 6°, 5°, 4°, 3°, 2°, 1° von der Strahlachse A des eingestrahlten Lichts 20 weggestreut wird, vorzugsweise als ungestreutes Licht interpretiert. Mit einem großen Akzeptanzwinkelbereich kann ein hohes Signal-Rausch-Verhältnis erreicht werden, mit einem kleinen Bereich ist die Linearität bei hohen Konzentrationen besser.

Wiederum befindet sich in dem Beispiel die zu untersuchende Probe in einer Kapillare 30, die auf einer Oberfläche 77 liegt. Das Licht eines ankommenden Lichtstrahles 20 wird von Partikeln in der Probenlösung 13 teilweise unter verschiedenen Winkeln weggestreut (siehe Streulicht 24). Der Lichtstrahl des einfallenden Lichtes wird an der Oberfläche 77 reflektiert und kehrt als Lichtstrahl 22 entgegengesetzt zum eingestrahlten Lichtstrahl 20 zurück. Die Intensität des Lichtstrahles 20, 22, der an der Oberfläche 77 reflektiert wurde und so zwei Mal das Probenvolumen 13 durchlaufen hat, hängt von der Stärke der Lichtstreuung in der Probe ab. Die Intensität des reflektierten Strahles 22 wird von einem Detektor 100 gemessen, dessen Akzeptanzbereich kollinear mit dem Lichtstrahl 20 bzw. den Lichtstrahlen 20, 22 liegt. Die Wellenlänge der ankommenden / eingestrahlten Lichtstrahlen 20 und der reflektierten Lichtstrahlen 22 ist vorzugsweise so gewählt, dass die zu messende Probe in diesem Bereich möglichst wenig Licht absorbiert. Damit kann erreicht werden, dass die Lichtabschwächung vorwiegend durch Wegstreuung (Extinktion) stattfindet und nicht durch Absorption. Ein weiterer Vorteil dieses erfindungsgemäßen Verfahrens besteht auch darin, dass an der Oberfläche 77 reflektierende Strahlen 26 die Messung nicht stören.

Fig. 17a zeigt die Oberfläche 77 des erfindungsgemäßen Temperierkörpers mit mehreren darauf angeordneten Kapillaren 30 in einer Draufsicht. Die Oberfläche 77 hat eine Länge L und Breite B, wobei die Oberflächenschicht zudem eine Tiefe T aufweist, wie aus den Figuren 17a und 17b ersichtlich. Vorzugsweise ist die Länge L länger als die Breite B. Zudem ist es bevorzugt, dass die Kapillaren 30 sich für die Messung über die Breite B der Oberfläche 77 erstrecken und die Kapillaren vorzugsweise länger sind als die Breite B, sodass die beiden Enden der Kapillaren über die Oberfläche 77 überstehen. Um die Kapillaren 30 über Kontakt zu temperieren ist es bevorzugt, dass die Kapillaren direkt auf der Oberfläche 77 des Temperierelements liegen, d.h., in direktem Kontakt mit der Oberfläche 77 stehen. Gemäß einer weiteren bevorzugten Ausführungsform kann es zudem vorteilhaft sein, zumindest einen Bereich so auszubilden, dass ein Abschnitt einer Kapillare nicht in direktem Kontakt mit der Oberfläche steht, während andere Bereiche dieser Kapillare in Kontakt mit der Oberfläche sind. Insbesondere ist ein Bereich ohne direkten Kontakt für optische Messung vorteilhaft, wie nachfolgend diskutiert wird.

Gemäß einer bevorzugten Ausführungsform kann in der Oberfläche 77 eine Aussparung 90 vorgesehen sein, beispielsweise in Form einer Rille, Nut, Mikronut oder "Grabens" 90, sodass in dem Bereich der Nut 90 kein direkter Kontakt der Kapillare zur Oberfläche 77 besteht. Die Nut 90 erstreckt sich vorzugsweise über zumindest einen Bereich des Temperierelements, auf dem die Kapillaren während der Messung liegen. Vorzugsweise ist die Nut 90 im mittigen Bereich bezüglich der Breite des Temperierelements ausgebildet, sodass jede Kapillare in einem mittigen Messbereich 90 keinen direkten Kontakt mit der Oberfläche 77 hat. Rechts und links dieses Bereichs 90 (bezüglich der Breite des Temperierelements) steht die Kapillare 30 jedoch in direktem Kontakt mit der Oberfläche, um eine Kontakt-Temperierung sicherzustellen.

Die Nut 90 ist vorzugsweise zwischen 1-10 mm, bevorzugter zwischen 2-8 mm, weiter bevorzugt zwischen 3-7 mm, beispielsweise 5 mm, weiter bevorzugt ca. 3 mm breit (entlang der Breite B). Erfindungsgemäß wird die erfindungsgemäße Rückreflektion des Lichts vorzugweise in diesem Nut-Abschnitt der Kapillaren erzeugt bzw. gemessen.

Vorzugweise hat die Nut eine Tiefe von ca. 10-30 $\mu$m. Insbesondere ist es bevorzugt, dass die Nut 90 eine Tiefe (siehe Richtung der Tiefe T in Fig. 17b) von mehr als der halben Kohärenzlänge des verwendeten Lichtes hat, um Interferenzeffekte in der Rückstreuung weiter zu unterdrücken. Störende Interferenzeffekte zeigen sich beispielsweise durch Newtonsche Ringe, die mit einer erfindungsgemäßen Nut unterdrückt oder sogar verhindert werden können. Erfindungsgemäß kann als Lichtquelle eine Laserlichtquelle oder eine LED verwendet werden. LED Lichtquellen, wie sie beispielsweise in der vorliegenden Erfindung verwendet werden, haben typischerweise eine Kohärenzwellenlängen im Bereich von ca. 15 $\mu$m, so dass eine Tiefe der Nut von > 7,5 $\mu$m bevorzugt ist. Insbesondere ist es bevorzugt, dass die Tiefe zwischen dem 1,5-fachen der halben Kohärenzwellenlänge und dem 10-fachen der halben Kohärenzwellenlänge liegt. Vorzugsweise liegt die Obergrenze der Tiefe beim 5-fachen der halben Kohärenzwellenlänge. Insbesondere sollte erfindungsgemäß die Nut nur so tief sein, um Interferenzen zu unterdrücken, im Gegenzug aber kein zu großes Luftpolster unter der Kapillare ausgebildet sein, da sonst die gewünschte Temperatur in der Kapillaren durch das Luftpolster gestört werden könnte. Die Nut hat zudem den weiter bevorzugten Vorteil, dass die Oberfläche der Kapillare 30 im Messbereich nicht direkt mit der Oberfläche 77 in Kontakt kommt, sodass ein zerkratzen der Oberfläche der Kapillare 30 und ein zerkratzen der Oberfläche des Temperierkörpers im Messbereich (Nut) durch die Kapillare unterdrückt bzw. verhindert werden können. Insbesondere kann erfindungsgemäß vermieden werden, dass die Oberfläche des Temperierkörpers zerkratzt wird, wohingegen ein mögliches Zerkratzen der Kapillaren tolerabel sein kann, da die Kapillaren vorzugsweise als Einwegartikel verwendet werden. Beispielsweise können erfindungsgemäß Kapillare verwendet werden, deren Material eine geringere Härte aufweist als Silizium.

Um eine effiziente Rückreflexion des Lichts vom Boden der Nut 90 zu gewährleisten, wird die Nut vorzugsweise in die Oberfläche des Temperierelements geätzt. Vorzugsweise hat das Temperierelement eine Oberflächenschicht aus Silizium, sodass die Nut 90 direkt in der Siliziumschicht ausgebildet ist. Gemäß einer bevorzugten Ausgestaltung der Erfindung wird die Nut in das Silizium geätzt. Das bevorzugte Ätzverfahren hat zudem den Vorteil, dass die Oberfläche des Bodens der Nut sehr glatt ausgebildet wird, sodass das Reflexionsverhalten dieser Fläche immer noch ausgezeichnet ist. Vorzugsweise hat die Oberfläche des Bodens eine mittlere Rauigkeit die vorzugsweise im Nanometerbereich liegt, vorzugsweise < ± 10 nm, vorzugsweise < ± 5 nm, beispielsweise ± 1-2 nm.

Gemäß einer bevorzugten Ausführungsform kann sich die Nut über einen Wesentlichen Teil der Oberfläche erstrecken, sodass beispielsweise alle zu messenden auf der Oberfläche 77 liegenden Kapillaren 30 über der Nut 90 angeordnet werden können. Wie in Figur 17a dargestellt, erstreckt sich die Nut 90 entlang der Länge L, sodass die Kapillaren 30 quer über die Nut 90 angeordnet werden können (siehe Fig. 17b). Gemäß einer weiteren bevorzugten Ausführungsform erstreckt sich die Nut 90 nicht über die gesamte Länge L, sodass vorzugsweise in den Randbereichen 91 keine Nut ausgebildet ist. Dies hat beispielsweise den Vorteil, dass das Silizium um die Nut 90 herum eine gleichmäßige Dicke aufweist und somit leichter zu bearbeiten ist (beispielsweise Schneiden oder Sägen).

Vorzugsweise wird als Oberfläche des Temperierelements Silizium verwendet. Vorzugweise wird reines (kristallines) Silizium verwendet, wie weiter unten ausführlicher diskutiert. Vorzugsweise ist die erfindungsgemäße Nut 90 entlang einer bevorzugten Kristallrichtung des kristallinen Siliziums ausgebildet, vorzugsweise entlang der [111] Richtung (Millersche Richtungsindizes).

Die Nut hat beispielsweise auch den Vorteil, dass Flüssigkeit die sich an der Außenseite der Kapillare befindet, nicht in den Messbereich, der sich vorzugsweise im Bereich der Nut befindet, gelangt. Da im Bereich der Nut der Abstand zwischen Kapillare und Temperierkörper größer ist als außerhalb des Bereichs der Nut, ist es für die Flüssigkeit an der Außenseite der Kapillare aufgrund der Kapillarkräfte günstiger außerhalb der Nut zu bleiben. So kann es beispielsweise passieren, dass beim Befüllen der Kapillaren mal Tröpfchen außen an der Kapillare hängen. Diese Tröpfchen können stören, wenn sie in den Messbereich gelangen. Die Kapillarekräfte, die größer sind je kleiner der Abstand von Kapillare zu Temperierkörper ist, halten diese Flüssigkeit aber außerhalb der Nut. So kann beispielsweise verhindert werden, dass die Flüssigkeit der Tröpfchen nicht in den Messbereich in der Nut.

Die Figuren 3a) - 3c) zeigen die Entstehung der Signale für eine erfindungsgemäße Fluoreszenz- und Extinktionsmessung. Ähnlich wie in der Figur 1 befindet sich die zu untersuchende Probe in einer Kapillare. Die zu untersuchende Probe enthält streuende/aggregierende Partikel (im Folgenden als Probe 12 bezeichnet) sowie fluoreszierende Partikel (im Folgenden als Probe 15 bezeichnet). Zur Messung der Probe wird vorzugsweise der Detektor über die Kapillare verschoben bzw. die Kapillare unterhalb des Detektors verschoben. Dieses Verschieben erfolgt vorzugsweise quer zur Längsachse der Kapillare. Alternativ können auch sowohl Kapillare als auch Detektor verschoben werden. Vorzugsweise soll jedoch eine Relativbewegung 80 zwischen Kapillare 30 und Detektor 100 während einer Messung stattfinden.

Bevor eine Kapillare 30 von den eingestrahlten Lichtstrahlen für die Fluoreszenz- und Extinktionsmessung 20, 21 erreicht wird, misst der Detektor kein Fluoreszenzlicht 23 (obere Reihe; Signal (Fluoreszenz)) und keine Abschwächung im reflektierten Licht 22 für die Extinktionsmessung 22 (untere Reihe; Signal (Extinktion)). Entsprechend ist in den Diagrammen in Fig. 3a eine waagrechte Linie dargestellt.

Während der (Relativ-)Bewegung 80 der Kapillare 30 unter den Erfassungsbereich des optischen Systems erhöht sich die gemessene Fluoreszenzenzintensität 23, und die Intensität des reflektierten Strahles 22 nimmt durch Brechung an der Kapillare und durch Wegstreuung in der Probe 12 ab (siehe Fig. 3b).

Wenn die Kapillare mit der Probe den Erfassungsbereiches der Optik verlässt, erhält man vorzugsweise Signale, die dem Einfahren in den Erfassungsbereich entspricht. Dies liegt an der symmetrischen Anordnung des optischen Systems bzw. der symmetrischen Bewegung über die Kapillare. Die Richtung 80 der Bewegung zwischen Proben und optischem System spielt somit keine Rolle.

Erfindungsgemäß können mehrere Proben, die sich in mehreren Kapillaren befinden kontinuierlich nacheinander gemessen werden. Die mehreren Kapillaren können vorzugsweise auf einem Probenträger angeordnet sein. D.h., durch eine vorzugsweise kontinuierliche Bewegung eines Probenträgers kann eine Vielzahl an Proben mit hoher Datendichte (Datenpunkte pro Probe pro Zeiteinheit) aufgenommen werden. So ist es beispielsweise möglich, Messfrequenzen bis über 100kHz zu erhalten. Ein weiterer Vorteil dieses erfindungsgemäßen Verfahrens ist zudem der geringe Justageaufwand des Systems. Zudem bieten Kapillare 30 als Probenkammerformat ein einfaches Befüllen durch automatisches Aufziehen der Probe in die Kapillare durch Kapillarkräfte was beispielhaft auch die Befüllung mit hochviskosen Lösungen ermöglicht. Die Kapillare liegen vorzugsweise direkt mit gutem Wärmekontakt auf der Oberfläche 77 auf.

Fig.4 a) zeigt einen Querschnitt durch drei verschiedene Proben 11, 12, 13 in Kapillaren 30. Die erste Probe 11 streut das von einer Quelle emittierte erzeugte Licht 20 nicht, so dass der größte Teil 22 der eingestrahlten Lichtstrahlung 20 zurück in Richtung Objektivlinse und Detektor 100 reflektiert wird. Die anderen beiden Proben 12 und 13 streuen einen Teil des einfallenden Lichts 20 in andere Richtungen außerhalb des Akzeptanzwinkels des Detektors 100. Durch die Probe 13 wird mehr des einfallenden Lichts als durch die Probe 12 gestreut, was durch die mehreren Streupfeile 24 dargestellt wird.

Wie bereits in Bezug auf die Fig. 3 beschrieben, ist es bevorzugt, dass die Proben während einer Messung relativ zum optischen System bewegt werden. Fig.4 b) zeigt einen typischen Verlauf der mit dem Detektor 100 gemessenen Lichtintensität in Abhängigkeit der horizontalen Position der Proben (Extinktionsmessung). Die gemessene Intensität (Helligkeit [I]) hängt zum einen von der Lichtbeugung an den Kapillarwänden 30 ab und zum anderen von der Extinktion in der Probe. Die Lichtbeugung an den Kapillarwänden kann in guter Näherung bei verschiedenen Proben als identisch angenommen werden. Da die Proben 12 und 13 jedoch einen größeren Anteil des einfallenden Lichtes 20 als die Probe 11 wegstreuen, wird weniger Licht 22 zurück reflektiert. Somit nimmt die Helligkeit (Intensität) in den Proben 12 und 13 in einem größeren Ausmaß ab.

Fig. 4 c) zeigt einen möglichen Verlauf der Extinktion in Abhängigkeit von der Position der Proben. Die Formel zur Berechnung der Extinktion hat im Allgemeinen die Form

$$E(x) = -\log_{10}\left(\frac{I(x)}{I_0(x)}\right)$$

I0(x) kann im einfachsten Fall eine Konstante sein, oder der Intensitätsverlauf bei einer wassergefüllten Kapillare oder der Intensitätsverlauf beim Start einer Messung, bevor die Extinktion durch Temperatur-induzierte Bildung von Aggregaten eingesetzt hat.

Die gesuchte Messgröße "Extinktion" (Fig.4 d)) ergibt sich durch Integration des Extinktionsverlaufes E(x). Die Integrationsgrenzen liegen vorzugsweise symmetrisch um die jeweilige Kapillare. Um Schwankungen der Helligkeit der Lichtquelle oder der Empfindlichkeit des Detektors auszugleichen, kann die ermittelte Extinktion noch um einen Referenzwert korrigiert werden, der durch Integration der Kurve E(x) in einem Bereich ohne Kapillare errechnet wird (siehe Fig. 4c: "Referenzfläche"). Vorzugsweise wird diese Korrektur für jede einzelne Kapillar individuell mit einem Bereich ohne Kapillare unmittelbar neben dieser einzelnen Kapillare durchgeführt. Dies ist erfindungsgemäß beispielsweise möglich, da die Probe, anders als bei Messverfahren aus dem Stand der Technik, vorzugsweise relativ zum Messsystem bewegt wird.

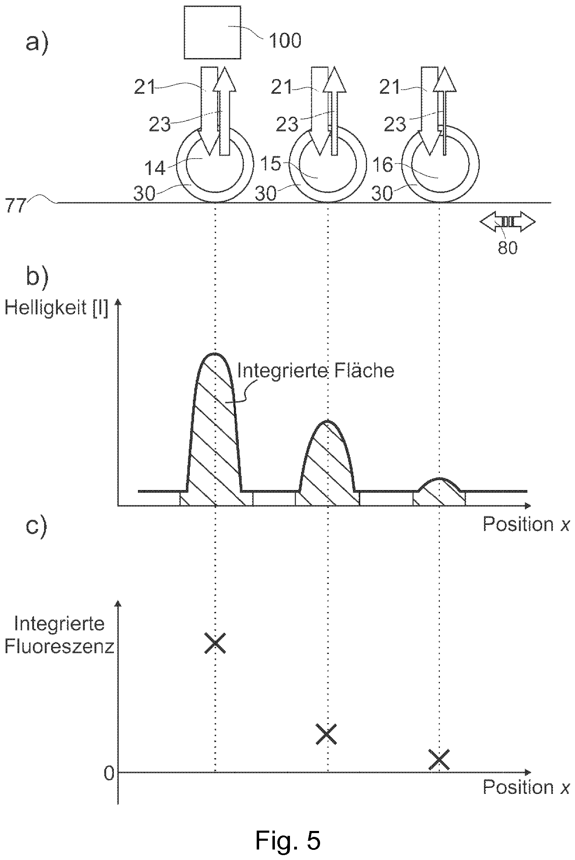

Fig. 5 erläutert beispielhaft eine mögliche Verarbeitung der Messdaten aus Fig. 3 am Beispiel von drei Proben mit starker 14, mittlerer 15 und geringer 16 Fluoreszenz.

Die Intensität des von den Proben emittierten Fluoreszenzlichts ist in Abhängigkeit von der Bewegung bzw. der Position des Detektors 100 zur Kapillare in Fig. 5b dargestellt. Zur Bestimmung eines "Fluoreszenzwertes" wird über den Betrag der Verschiebung 80 der Proben relativ zum optischen System integriert (siehe Fig. 5c). Die Integrationsgrenzen umfassen vorzugsweise symmetrisch eine einzige Kapillare. Die integrierte Fluoreszenzintensität entspricht vorzugsweise der gesuchten Messgröße der Fluoreszenz einer Probe. Möglich ist auch die Messung von Fluoreszenzintensitäten bei zwei oder mehreren verschiedenen Wellenlängen. In diesem Fall ist vorzugsweise das Verhältnis der integrierten Fluoreszenzintensitäten die gesuchte Messgröße "Fluoreszenz-Verhältnis".

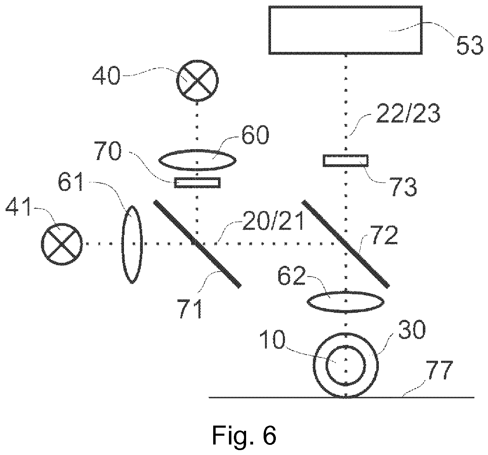

Fig. 6 zeigt eine beispielhafte Ausführung eines erfindungsgemäßen Systems zur Messung von Fluoreszenz und Extinktion. Vorzugsweise kann diese Messung von Fluoreszenz und Extinktion nacheinander, quasi gleichzeitig bzw. gleichzeitig erfolgen. Eine (erste) Lichtquelle 40, beispielsweise eine LED, erzeugt Lichtstrahlung 21 mit einer (ersten) Wellenlänge 21, die im Probenvolumen 10 die Emission von Fluoreszenzstrahlung anregt. Der Anregungsfilter 70 unterdrückt eventuelle Strahlung der Lichtquelle 40 in nicht erwünschten Wellenlängenbereichen. Eine (zweite) Lichtquelle 41 erzeugt Lichtstrahlung 20 in einem (zweiten) Wellenlängenbereich, in dem das Probenvolumen 10 nur geringe Absorption hat. Das Licht der beiden Lichtquellen 40, 41 wird vorzugsweise mit den optischen Linsen 60, 61 kollimiert und von einem dichroitischen Strahlteiler 71 zu einem kollinearen Strahl vereinigt.

Der Strahlteiler 72 hat vorzugsweise im (ersten) Wellenlängenbereich 40 eine hohe Reflektivität. Zudem ist es vorteilhaft, wenn der Strahlteiler 72 im Wellenlängenbereich der Fluoreszenzemission von der Probe eine hohe Transmission aufweist. Auch ist es weiter bevorzugt, dass der Strahlteiler 72 im Wellenlängenbereich der (zweiten) Lichtquelle 41 eine teilweise Transmission und teilweise Reflexion aufweist. Diese Anforderungen erfüllt beispielsweise ein dichroitischer Strahlteiler, wenn die Wellenlänge von 41 mit der Fluoreszenzemission von 10 übereinstimmt. Im allgemeineren Fall ist der Strahlteiler 72 ein trichroitischer Strahlteiler.

Vom Strahlteiler 72 wird das Licht der ersten und zweiten Wellenlänge 21, 20 auf die Probe 10 in der Kapillare 30 reflektiert. Die Objektivlinse 62 fokussiert das einfallende Licht auf die Probe 10. Das Licht von der ersten Lichtquelle 40 erzeugt in der Probe 10 Fluoreszenzstrahlung, die von der Linse 62 kollimiert wird. Das Licht im einfallenden Strahl, der von der zweiten Lichtquelle 41 erzeugt wird, gelangt durch die Probe 10 und die Kapillare 30 auf die Oberfläche 77, wird dort reflektiert bzw. zurückreflektiert (Englisch: backreflection) und gelangt ein zweites Mal durch die Probe 10 und die Kapillare 30.

Die Oberfläche 77 besteht vorzugsweise aus einem Material mit geringer Eigenfluoreszenz und hoher Reflektivität im Wellenlängenbereich der zweiten Quelle 41 zur Extinktionsmessung. Die reflektierte Strahlung wird von der Linse 62 wieder kollimiert. Eventuell im Probenvolumen vorhandene Partikel streuen das einfallende Licht, so dass nur noch ein geringerer Teil des ursprünglich eingestrahlten Lichts von der Objektivlinse 62 aufgefangen wird. Die Intensität des zur Linse 62 zurückreflektierten Lichts hängt dadurch wesentlich von Konzentration und Größe der Partikel ab und damit von der Extinktion der Probe.

Der Filter 73 unterdrückt vorzugsweise das Fluoreszenz-Anregungslicht von der (ersten) Lichtquelle 40. Der Detektor 53 misst vorzugsweise Wellenlängen-selektiv die Intensität des von der Probe kommenden Lichtstrahls. Vorzugsweise kann mit dem Detektor 53 sowohl das Licht der zweiten Wellenlänge, d.h. das Licht das durch die Probe durchtritt und zurückreflektiert wird, gemessen werden als auch das Fluoreszenzlicht, d.h. Licht der Fluoreszenzemission der Probe. Zudem bedeutet Wellenlängen-selektiv, dass die Intensitäten bei den unterschiedlichen Wellenlängen vorzugsweise getrennt bestimmt werden können.

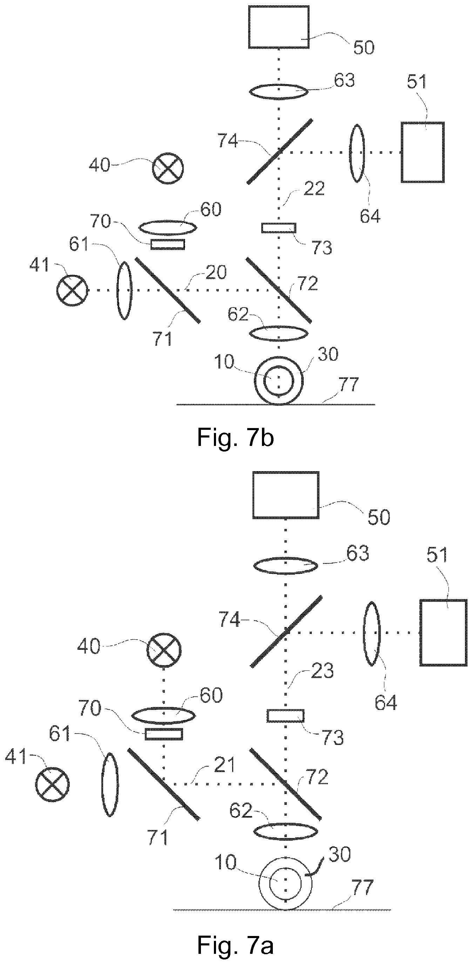

Fig. 7a) zeigt eine weitere erfindungsgemäße Ausführungsform des Systems mit eingezeichnetem Strahlengang bei der Fluoreszenzmessung. Im Unterschied zur Fig. 6 hat das System jedoch (mindestens) zwei Detektoren.

Die beiden Detektoren 50, 51 dienen zur Messung einer Fluoreszenzintensität bei zwei verschiedenen Wellenlängen. Wählt man beispielsweise 330nm und 350nm als detektierte Wellenlängen, erhält man aus dem Verhältnis der beiden Signale Informationen zur Struktur von Makromolekülen, die sich im Probenvolumen 10 befinden.

Bei dieser Ausführungsform liegt die Wellenlänge der (zweiten) Lichtquelle 41 zur Extinktionsmessung im Bereich der Fluoreszenzemission der Probe 10. Daher sollte während der Messung der Fluoreszenz die Lichtquelle 41 ausgeschaltet sein. Eine sequenzielle bzw. quasi gleichzeitige Messung kommt dadurch zustande, dass Extinktion und Fluoreszenz schnell abwechselnd gemessen werden. Der zeitliche Abstand zwischen zwei Datenpunkten eines Messtyps muss dabei so gering sein, dass der Unterschied zwischen zwei Messwerten geringer ist, als die Messunsicherheit eines Messwertes Beispiel: Extinktion einer hoch konzentrierten Probe ändert sich bei Temperaturen über 80°C mit ca. 0.2mAU/s (Milli Absorption Units / Sekunde) Die Messunsicherheit bei der Extinktion beträgt beispielsweise ca. 0.2mAU. Entsprechend wird vorzugsweise mindestens 1x pro Sekunde Extinktion gemessen und auch mindestens 1x pro Sekunde die Fluoreszenz. Bei dieser Ausführungsform transmittiert der Bandpass 73 einen Teil der Fluoreszenzstrahlung 23, beispielsweise im Bereich von 320nm bis 360nm. Der Strahlteiler 74 trennt die Fluoreszenzstrahlung in zwei Strahlen mit Wellenlängenbereichen, beispielsweise 320nm - 340nm und 340nm - 360nm. Die Strahlen werden mit den Konzentratorlinsen 63, 64 auf die beiden Detektoren 50, 51 gebündelt. Der Quotient beider Messsignale ist die gesuchte Messgröße.

Fig. 7b) zeigt die beispielhafte Ausführung des Systems aus Fig. 7a), jedoch mit eingezeichnetem Strahlengang bei der Extinktionsmessung. Die zweite Lichtquelle 41 sendet Lichtstrahlung 20 aus, die nach Reflexion an der Grundplatte 77 zwei Mal durch die Probe 10 gelangt und als Lichtstrahl 22 nach oben verläuft. In der Probe 10 wird durch Wegstreuung aus dem Detektionsbereich die Intensität der Lichtstrahlung abgeschwächt. Die Wellenlänge der (zweiten) Lichtquelle 41 liegt vorzugsweise im Transmissionsbereich des Filters 73. Je nach Wellenlänge der Lichtquelle 41 verteilt sich das Licht danach auf die beiden Detektoren 50, 51. Vorzugsweise liegt die Wellenlänge bei ca. 350nm, so dass der größte Teil des Lichtes von einem einzigen Detektor gemessen wird.

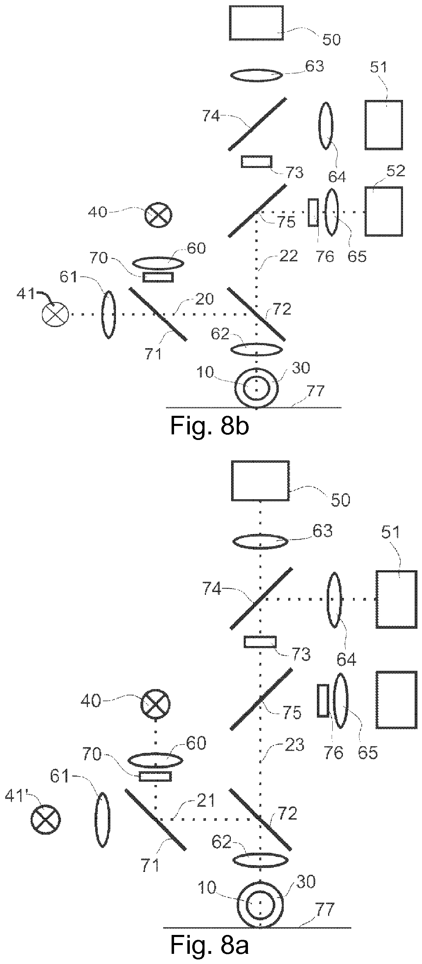

Fig.8a) zeigt eine beispielhafte Ausführung des Systems aus Fig. 6, das im Vergleich zur Ausführung in Fig. 7 um einen zusätzlichen Detektionszweig erweitert ist. Der Strahlengang für die Fluoreszenz ist eingezeichnet, der dem Strahlengang in Fig. 7a entspricht. Der zusätzliche dichroitische Strahlteiler 75 ist im Wellenlängenbereich, der von den Detektoren 50, 51 gemessen wird, transparent.

Fig. 8b) zeigt das System aus Fig. 8a) mit eingezeichnetem Strahlengang für die Extinktionsmessung. Im Vergleich zum System aus Fig. 7 liegt der Wellenlängenbereich der Lichtquelle 41 außerhalb des von den Detektoren 50, 51 gemessenen Wellenlängenbereiches, beispielsweise 380nm. Dadurch kann die Lichtquelle 41 während der Messung der Fluoreszenz eingeschaltet bleiben und es muss nicht zwischen den Messtypen Fluoreszenz und Extinktion umgeschaltet werden. Der Strahlteiler 72 ist im Wellenlängenbereich von Quelle 41 teilweise durchlässig. Idealerweise beträgt das Transmissions/ReflexionsVerhältnis 1:1.

Der Strahlteiler 75 lenkt das Licht aus der (zweiten) Lichtquelle 41 auf den Detektor 52, nachdem es durch Extinktion in der Probe 10 abgeschwächt wurde. Der Bandpass 76 reduziert vorzugsweise den Anteil an Fluoreszenzlicht auf den Detektor 52.

Durch diese Ausführungsform mit drei Detektoren 51, 52, 53 können Extinktion und Fluoreszenz-Verhältnis gleichzeitig kontinuierlich gemessen werden. Außerdem kann die Empfindlichkeit des Detektors 52 auf die Intensität der Strahlung aus der Lichtquelle 41 individuell angepasst werden. Diese kann für eine rauscharme Messung der Extinktion beispielsweise deutlich höher eingestellt sein. In einer vorteilhaften Ausführungsform werden die Signale der Detektoren mit einem 24 Bit Analog-Digital Konverter (ADC) digitalisiert der alle drei Detektorkanäle gleichzeitig einlesen kann, beispielsweise mit einer Rate von 4 kHz.

Fig. 9 ist ein Diagramm, in dem die Reflektivität in Abhängigkeit der Wellenlänge für Silizium gezeigt wird. Insbesondere zeigt Fig. 9 die gute Reflektivität von Silizium im UV-Bereich. Diese ist besonders bevorzugt, damit die zum Detektor reflektierte Lichtintensität bei der Extinktionsmessung möglichst hoch ist. Insbesondere ermöglicht eine hohe Lichtintensität eine Messung mit geringem Rauschanteil. Weitere vorteilhafte Eigenschaften von Silizium sind die quasi Abwesenheit von Eigenfluoreszenz bei den verwendeten Wellenlängen, die gute mechanische Verarbeitbarkeit und die hohe chemische Resistenz.

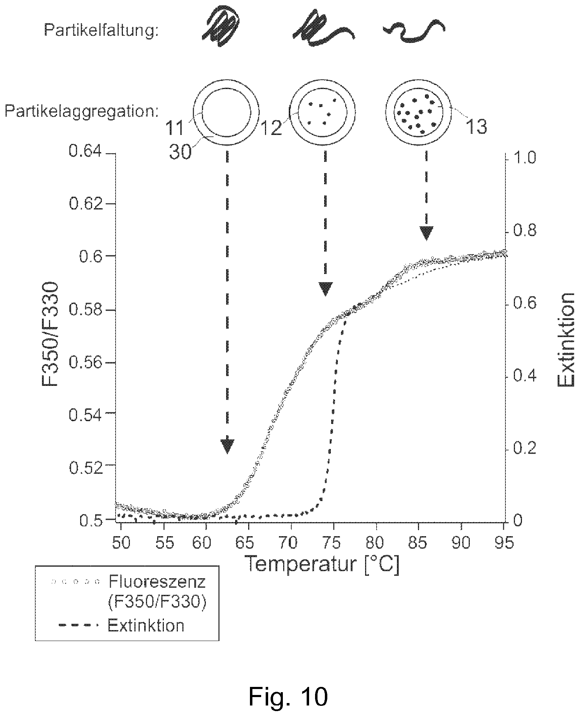

Fig. 10 zeigt beispielhaft eine Messung bei der mit dem in Fig. 6 beschrieben erfindungsgemäßen System. Gezeigt wird sowohl die temperaturabhängige Proteinentfaltung, als auch die temperaturabhängige Aggregation eines Antikörpers. Im gezeigten Beispiel setzt die Entfaltung einer der Untereinheiten des Antikörpers bereits ab 60°C ein, was durch eine charakteristische Änderung des Fluoreszenzverhältnisses zwischen der Emission bei 350 und 330 nm gekennzeichnet ist. Ein Anstieg der Aggregation, und somit der Extinktion, ist jedoch erst ab 73°C zu verzeichnen, was darauf schließen lässt, dass eine Entfaltung der thermisch instabileren Proteindomäne nicht zur Aggregation des Antikörpers beiträgt.

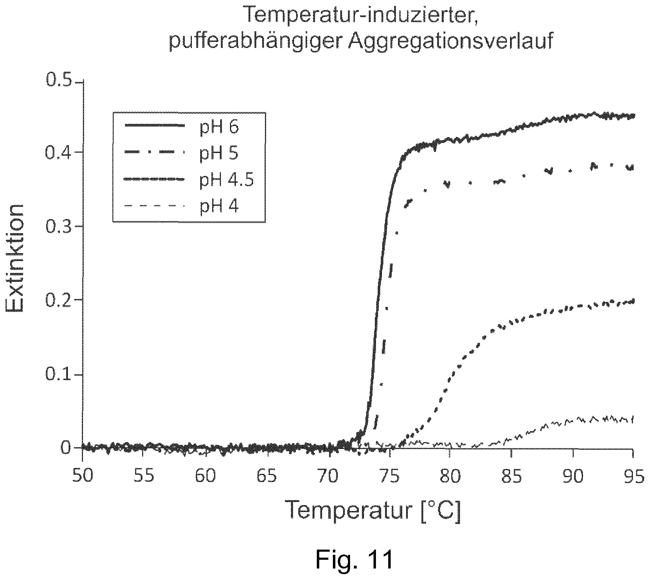

Fig. 11 zeigt beispielhaft die Messung der Extinktion eines Antikörpers (Rituximab) mit einer Stoffmengenkonzentration von 1 mg/ml in 25 mM Acetat-Puffer bei unterschiedlichen pH-Werten zwischen pH 4 und pH6. Je 10 μl der Lösung in Kapillaren wurden von 50 bis 95°C mit einer Heizrate von 1°C/min erhitzt. Ein Anstieg der Extinktion ist bei erhöhten Temperaturen > 72 °C zu verzeichnen, was auf Aggregation zurückzuführen ist. Das Ausmaß des Extinktionsanstiegs hängt vom pH-Wert der Lösung ab, wobei niedrigere pH-Werte der Temperatur-induzierten Aggregation entgegenwirken. Dies ist zum einen durch ein späteres Einsetzen der Extinktionszunahme ("Aggregation-onset Temperatur") und zum anderen durch eine insgesamt niedrigere Maximalextinktion gekennzeichnet.

Fig. 12 zeigt beispielhaft die Analyse der chemischen Stabilität der Proteins Lysozym in 10 mM Citrat Puffer pH 4 bei unterschiedlichen Guanidinium-Hydrochlorid Konzentrationen. 1 mg/ml Lysozym wurde in 48 Lösungen mit zunehmender Guanidinium-Chlorid Konzentration angesetzt, und je 10 $\mu$l der jeweiligen Lösungen in Kapillaren gefüllt, diese auf dem Kapillarträger platziert und fixiert, und anschließend bei 20°C, 30°C und 40°C ein Kapillar-Scan durchgeführt. Anschließend werden die erhaltenen Fluoreszenzverhältnisse gegen aufsteigende Guanidinium-Konzentrationen aufgetragen. Insbesondere zeigt das Fluoreszenz-Verhältnis bei allen Proben eine sigmoidale Zunahme mit steigender Guanidinium-Konzentration, welche direkt proportional zum Anteil an entfaltetem Protein ist. Mit steigender Temperatur wird das Protein zunehmend destabilisiert, was durch eine Verschiebung der Datenpunkte zu niedrigeren Guanidinium-Konzentrationen gekennzeichnet ist.

Fig. 13 zeigt die beispielhafte Messung von dem Protein Streptavidin in PBS, pH 7.3, bei unterschiedlichen Stoffmengenkonzentrationen von 50 mg/ml bis 7 $\mu$g/ml. Der Kapillar-Scan verdeutlicht die unterschiedlichen Fluoreszenzintensitäten in den Kapillaren. Das obere Diagramm zeigt den Kapillar-Scan zu Beginn der Messung der thermischen Entfaltung. Alle Konzentrationen wurden als Duplikate gemessen. Die Höhe der Peaks entspricht der Fluoreszenzintensität in den Kapillaren bei einer Emissionswellenlänge 350 nm. Das Abfallen der Fluoreszenz bei hoher Streptavidin-Konzentration ist durch den *inner filter Effekt* zu erklären, der durch die starke Absorption des Anregungslichts und einer dadurch verringerten Eindringtiefe zustande kommt (somit eine geringere Fluoreszenz). Das untere Diagramm zeigt den Temperaturverlauf des Fluoreszenzverhältnisses bei 350 und 330 nm. Diese Entfaltungskurven zeigen, dass für sämtliche Konzentrationen Entfaltungsprofile aufgenommen wurden. Bei allen Konzentrationen ist ein klarer Entfaltungsprozess zu erkennen. Bei hohen Streptavidin-Konzentrationen ist der Schmelzübergang zu höheren Temperaturen verschoben, was auf eine intramolekulare Stabilisierung des Proteins zurückzuführen ist.

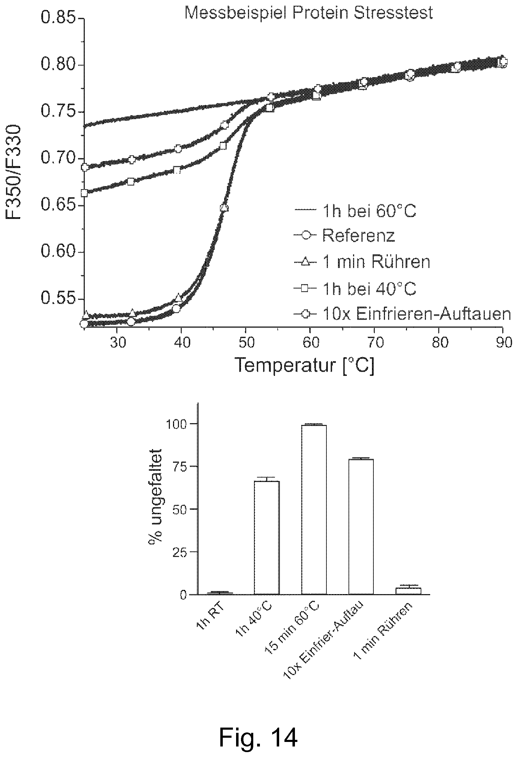

Fig. 14 zeigt beispielhafte Daten eines Forced Degradation Tests für das Protein MEK1-Kinase. Von dem Protein wurde eine Lösung mit einer Konzentration von 1 mg/ml in 50 mM Hepes pH 7.4, 150 mM NaCl und 2 mM DTT hergestellt, und in 5 Aliquots a 50 $\mu$l aufgeteilt. Während ein Aliquot bei 4°C gelagert wurde und als Referenz diente, wurden die verbleibenden Aliquots unterschiedlichen Bedingungen ausgesetzt - Inkubation bei erhöhter Temperatur, Einfrier-Auftau-Zyklen, starkes Rühren. Anschließend wurden alle Proben in Kapillaren gefüllt, auf den Kapillarträger überführt und angepresst, und die thermische Entfaltung bei einer Heizrate von 1°C/min von 25°C bis 90°C über die Fluoreszenz detektiert. Das obere Diagramm zeigt die Entfaltungskurven der Proben. Je nach vorausgegangener Behandlung sind die Anfangsniveaus der Entfaltungskurven unterschiedlich, was auf unterschiedliche Anteile an bereits entfaltetem Protein hinweist. Das untere Diagramm zeigt eine Quantifizierung des Anteils an ungefaltetem Protein in %, wobei die Probe der 4°C Inkubation als 0% entfaltet, und die Probe nach 15 minütiger Inkubation bei 60°C als Referenzen benutzt wurde.

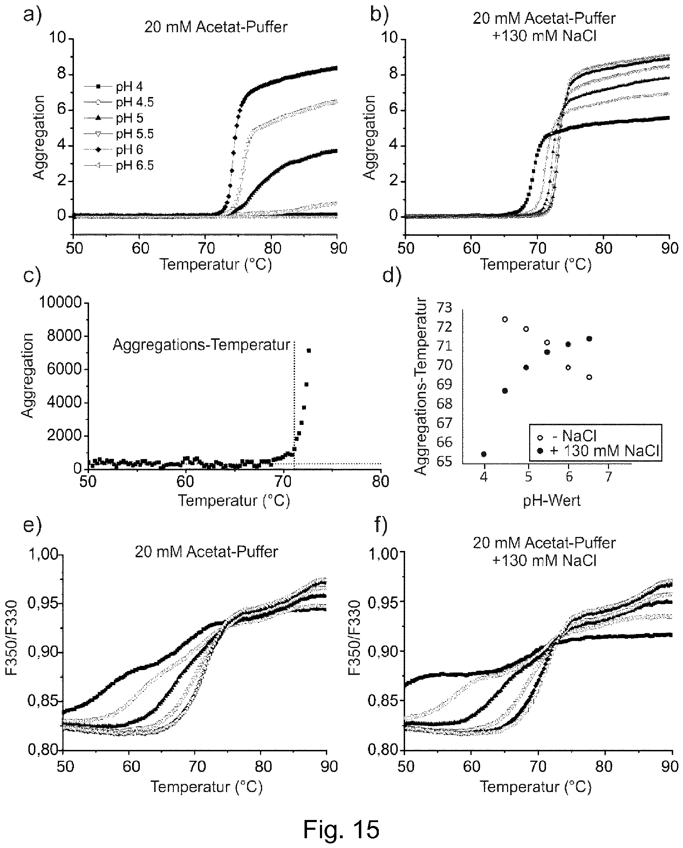

Fig. 15 zeigt beispielhafte Daten eines Puffer-Screenings zur Identifikation optimaler Bedingungen für die Lagerung von Antikörpern. Ein monoklonaler Antikörper wurde bei einer Konzentration von 5 mg/ml in Acetat-Puffer mit unterschiedlichen pH-Werten sowie in Abwesenheit und Gegenwart von 130 mM NaCl gelagert. Je 10 $\mu$l jeder Antikörper-Lösung wurden anschließend in Glaskapillaren gefüllt und die temperaturabhängige Proteinentfaltung über die Fluoreszenzänderung, sowie temperaturabhängige Aggregation über die Extinktionszunahme bei einer Heizrate von 1°C/Minute gemessen. Fig. 15 a) und b) zeigen die temperaturabhängige Zunahme der Aggregation. Im gezeigten Fall steigt die Gesamtaggregation mit zunehmendem pH-Wert an, was durch größere Amplituden im Aggregationssignal gekennzeichnet ist. Der Zusatz von physiologischen Salzkonzentration führt zu einer weiteren Zunahme der Aggregation bei allen pH-Werten (b). Abbildungen c) und d) zeigen beispielhaft die Bestimmung der *Aggregation-Onset* Temperatur, welche der niedrigsten Temperatur entspricht bei der ein signifikanter Anstieg der Extinktion in Relation zur Basislinie verzeichnet wird. Abbildung d) zeigt beispielhaft die unterschiedliche Abhängigkeit der Aggregationstemperatur vom pH-Wert und der Salzkonzentration. Abbildung e) und f) zeigen Fluoreszenzdaten die erfindungsgemäß gleichzeitig mit den in Fig.15 a) und b) gezeigten Aggregationsdaten aufgenommen werden. Der Antikörper zeigt mit zunehmendem pH-Wert der Lösung eine größere thermische Stabilität. Des Weiteren wirkt sich NaCl negativ auf die thermische Stabilität aus, was durch ein Einsetzen der Proteinentfaltung bei niedrigeren Temperaturen ersichtlich ist. Durch vergleichbare Experimente können Bedingungen ermittelt werden, unter denen die thermische Stabilität eines Proteins, beispielhaft eines Antikörpers, maximal, und die Aggregation minimal sind.

Fig. 16 zeigt ein beispielhaftes Absorptionsspektrum eines Proteins.

Die Erfindung umfasst ebenfalls die genauen oder exakten Ausdrücke, Merkmale, numerischen Werte oder Bereiche usw., wenn vorstehend oder nachfolgend diese Ausdrücke, Merkmale, numerischen Werte oder Bereiche im Zusammenhang mit Ausdrücken wie z.B. "etwa, ca., um, im Wesentlichen, im Allgemeinen, zumindest, mindestens" usw. genannt wurden (also "etwa 3" soll ebenfalls "3" oder "im Wesentlichen radial" soll auch "radial" umfassen). Der Ausdruck "bzw." bedeutet überdies "und/oder".

**LEGENDE DER BEZUGSZEICHEN**

| | |
|---|---|
| 10: | Probe |
| 11: | Probe ohne streuenden/aggregierenden Partikel |
| 12: | Probe mit einigen streuenden/aggregierenden Partikeln |
| 13: | Probe mit stark streuenden/aggregierenden Partikeln |
| 14: | Probe mit vielen fluoreszierenden Partikeln |
| 15: | Probe mit einigen fluoreszierenden Partikeln |
| 16: | Probe mit wenigen fluoreszierenden Partikeln |
| 20: | Eingestrahltes Licht für Extinktionsmessung |
| 21: | Anregungslicht für Fluoreszenz |
| 22: | Reflektiertes Licht |
| 23: | Emissionslicht Fluoreszenz |
| 24: | Streulicht in spezifischem Streuwinkel Q |
| 25: | "Ungewolltes" Streulicht |
| 26: | "Ungewolltes" reflektiertes Streulicht |
| 30: | Kapillare |
| 40: | Lichtquelle für Fluoreszenzanregung |
| 41: | Lichtquelle für Extinktion |
| 50: | Detektor 1 (Fluoreszenz und Extinktion) |
| 51: | Detektor 2 (Fluoreszenz und Extinktion) |
| 52: | Detektor 3 (Extinktion) |
| 53: | Detektionssystem |
| 60: | Kollimatorlinse für 40 |
| 61: | Kollimatorlinse für 41 |
| 62: | Objektivlinse |
| 63: | Konzentratorlinse für 50 |
| 64: | Konzentratorlinse für 51 |
| 65: | Konzentratorlinse für 52 |
| 70: | Anregungsfilter für 40 |
| 71: | Strahlteiler zur Kombination von 40 + 41 |
| 72: | Strahlteiler zur Trennung v. Anregung und Fluoreszenz |
| 73: | Fluoreszenz-Emissionsfilter |
| 74: | Strahlteiler zur Auftrennung v. Fluoreszenz |
| 75: | Strahlteiler zur Auftrennung v. Fluoreszenz und Extinktion |
| 76: | Extinktionsfilter |
| 77: | Reflektierende, nicht fluoreszierende Oberfläche, z.B. Silizium Oberfläche |
| 80: | Verfahrrichtungen des Kapillarträgers |
| 90: | Nut, Rille, Graben, Aussparung |
| 91: | Randbereich |
| 100: | Erfindungsgemäße Variante zur Detektion |
| 200: | Detektionsoptik für Streulicht gemäß gegenwärtigen Stand der Wissenschaft |

**Patentansprüche**

1. Verfahren zur optischen Messung zumindest der Stabilität und der Aggregation von Partikeln in einer flüssigen Probe (10), die sich in einem Probenbehälter (30) befindet, wobei das Verfahren folgende Schritte aufweist:

Bestrahlen der Probe (10) mit Licht mindestens einer ersten Wellenlänge (21), um die Partikel fluoreszent anzuregen,
Bestrahlen der Probe (10) mit Licht mindestens einer zweiten Wellenlänge (20), um die Streuung der Partikel zu untersuchen,
Messen des Fluoreszenzlichtes das von der Probe (10) emittiert wird; und
Messen von Extinktionslicht (22) bei der zweiten Wellenlänge, wobei das eingestrahlte Licht der zweiten Wellenlänge (20) den Probenbehälter (30) durchläuft, zurückreflektiert wird, den Probenbehälter in entgegengesetzter Richtung nochmals durchläuft und als Extinktionslicht austritt,
wobei die Stabilität auf der Basis des gemessenen Fluoreszenzlichtes und die Aggregation auf der Basis des gemessenen Extinktionslichtes bestimmt wird.

2. Verfahren nach Anspruch 1, wobei das Fluoreszenzlicht und das Extinktionslicht mit einem gemeinsamen optischen System gemessen werden und/oder gleichzeitig gemessen werden.

3. Verfahren nach Anspruch 1 oder 2, wobei die Bestrahlung der Probe

   i) mit der ersten und zweiten Wellenlänge nicht zeitgleich erfolgt; oder
   ii) die Bestrahlung mit der zweiten Wellenlänge dauerhaft erfolgt, wohingegen die Bestrahlung mit der ersten Wellenlänge intermittierend, vorzugsweise periodisch erfolgt.

4. Verfahren nach einem der vorhergehenden Ansprüche, wobei

   i) das Extinktionslicht und das Fluoreszenzlicht von einem gemeinsamen Detektor (53) gemessen werden;
   ii) das Extinktionslicht von einem ersten Detektor (50) und/oder einem zweiten Detektor (51) gemessen wird, und Fluoreszenzlicht einer ersten Fluoreszenz-Wellenlänge von dem ersten Detektor (50) und Fluoreszenzlicht einer zweiten Fluoreszenz-Wellenlänge von dem zweiten Detektor (51) gemessen wird; oder
   iii) das Extinktionslicht von einem ersten Detektor (52), Fluoreszenzlicht einer ersten Fluoreszenz-Wellenlänge von einem zweiten Detektor (51) und Fluoreszenzlicht einer zweiten Fluoreszenz-Wellenlänge von einem dritten Detektor (50) gemessen wird.

5. Verfahren nach einem der vorhergehenden Ansprüche, wobei der Probenbehälter (30) eine Kapillare (30) ist.

6. Verfahren nach einem der vorhergehenden Ansprüche, wobei der Probenbehälter (30) temperiert wird, vorzugsweise auf einem Temperierelement (77) aufliegt und durch Kontakt temperiert wird, wobei das Temperierelement weiter bevorzugt das eingestrahlte Licht der zweiten Wellenlänge zurückreflektiert, den Probenbehälter (30) in entgegengesetzter Richtung nochmals durchläuft und als Extinktionslicht austritt.

7. Verfahren nach Anspruch 6, wobei das Temperierelement (77) aus einem Material hergestellt ist

   i) mit einer geringen Eigenfluoreszenz <1% , und/oder
   ii) eine hohe Reflektivität > 30%, im Wellenlängenbereich der zweiten Wellenlänge aufweist und

   vorzugsweise Silizium aufweist oder aus reinem Silizium besteht.

8. Verfahren nach einem der vorhergehenden Ansprüche, wobei der Probenbehälter (30) während einer Messperiode relativ zum eingestrahlten Licht der ersten und/oder zweiten Wellenlänge und/oder zum Detektor verschoben wird, vorzugsweise mehrmals hin- und hergefahren wird und weiter bevorzugt mehrere Probenbehälter bzw. mehrere Kapillare (30) durch diese Relativbewegung gescannt werden, wobei während der Messperiode vorzugsweise mehrere Probenbehälter und/oder das optische System mehrmals kontinuierlich hin- und hergefahren werden und die Messungen des Fluoreszenzlichtes und/oder des Extinktionslichts während der Bewegung erfolgen.

9. Verfahren nach Anspruch 8, wobei

   i) ein Fluoreszenzwert bestimmt wird, indem die Intensität des Fluoreszenzlichts über die Verschiebung integriert wird und/oder
   ii) ein Extinktionswert bestimmt wird, indem die Intensität des Extinktionslichtes über die Verschiebung integriert wird.

10. Verfahren nach einem der vorhergehenden Ansprüche, wobei während einer Messperiode

   i) zur Bestimmung der thermischen Stabilität die Temperatur der Proben verändert wird, vorzugsweise erhöht wird;
   ii) zur Bestimmung der chemischen Stabilität die Konzentration an Denaturantien in verschiedenen flüssigen Proben unterschiedlich gewählt wird; und/oder
   iii) zur Bestimmung der zeitlichen Stabilität die Probe über einen Zeitraum von mehr als einer Stunde im Wesentlichen bei einer konstanten Temperatur gehalten wird.

11. Verfahren nach einem der vorhergehenden Ansprüche, wobei

i) die zweite Wellenlänge (20) so ausgewählt ist, dass von der Probe bzw. den Partikeln in der Probe weniger als 1%, 0,1%, 0,05% absorbiert werden,
ii) das Licht der zweiten und ersten Wellenlänge zu einem kollinearen Strahl vereinigt werden der in den Probenbehälter eingestrahlt wird, und/oder .
iii) das Extinktionslicht der zweiten Wellenlänge, das zurückreflektiert wird und in entgegengesetzter Richtung zur Einstrahlrichtung aus dem Probenbehälter austritt höchstens 5°, vorzugsweise weniger als 2°, weiter bevorzugt weniger als 1° von der Einstrahlrichtung abweicht.

12. Vorrichtung zur optischen Messung der Stabilität und der Aggregation von Partikeln in einer flüssigen Probe (10), die sich in einem Probenbehälter (30) befindet, insbesondere nach einem der vorhergehenden Ansprüche, wobei die Vorrichtung aufweist:

ein Trägerelement mit reflektierender Oberfläche (77) auf der die Probenbehälter (30) angeordnet sind,
eine erste Lichtquelle (40) zum Einstrahlen von Licht einer ersten Wellenlänge in den Probenbehälter, um die zu untersuchenden Partikel fluoreszent anzuregen,
eine zweite Lichtquelle (41) zum Einstrahlen von Licht einer zweiten Wellenlänge in den Probenbehälter, um die Streuung der Partikel zu messen,
einem ersten Detektor zum Messen des angeregten Fluoreszenzlichtes, das aus der Probe abgestrahlt wird,
einem zweiten Detektor zum Messen von Extinktionslicht (22) bei der zweiten Wellenlänge, wobei das eingestrahlte Licht der zweiten Wellenlänge (20) den Probenbehälter (30) durchläuft, von der reflektierenden Oberfläche (77) zurückreflektiert wird, den Probenbehälter in entgegengesetzter Richtung nochmals durchläuft und als Extinktionslicht austritt, und einer Auswerteinrichtung, die dazu eingerichtet ist basierend auf dem gemessenen Fluoreszenzlicht die Stabilität
der Partikel bestimmt und basierend auf dem gemessenen Extinktionslichts die Aggregation der Partikel bestimmt.

13. Vorrichtung nach Anspruch 12, mit einem Temperierelement mit einer reflektierenden Oberfläche an der das eingestrahlte Licht der zweiten Wellenlänge zurückreflektiert wird, wobei die reflektierende Oberfläche vorzugsweise aus Silizium besteht, vorzugsweise aus kristallinem Silizium, und
wobei die Vorrichtung vorzugsweise dazu eingerichtet ist, mindestens einen Probenbehälter (30) auf der Oberfläche zur Messung anzuordnen, wobei der mindestens eine Probenbehälter (30) vorzugsweise eine Kapillare (30) ist.

14. Vorrichtung nach Anspruch 12 oder 13 oder Verfahren nach einem der Ansprüche 1 bis 11, wobei an der Oberfläche des Temperierelements mindestens eine Nut (90) ausgebildet ist, der Probenbehälter über der Nut angeordnet ist, und das eingestrahlte Licht der zweiten Wellenlänge (20) vom Boden der Nut (90) zurückreflektiert wird, wobei die Nut (90) vorzugsweise eine Breite zwischen 1-10 mm und einer Tiefe von mehr als der halben Kohärenzlänge des Lichtes der zweiten Wellenlänge hat.

15. Verwendung einer Vorrichtung nach einem der Ansprüche 12-14 zur Durchführung eines Verfahrens nach einem der Ansprüche 1 bis 11.

**Claims**

1. Method for optically measuring at least the stability and the aggregation of particles in a liquid sample (10), which is in a sample container (30), wherein the method comprises the following steps:

irradiating the sample (10) with light of at least a first wavelength (21), to fluorescently excite the particles,
irradiating the sample (10) with light of at least a second wavelength (20) to examine the scattering of the particles,
measuring the fluorescence light emitted by the sample (10); and
measuring the extinction light (22) at the second wavelength, wherein the irradiated light of the second wavelength (20) runs through the sample container (30), is reflected back, runs again through the sample container in opposite direction and exits as extinction light,
wherein the stability is measured on the basis of the measured fluorescence light and the aggregation on the basis of the measured extinction light.

2. The method according to claim 1, wherein the fluorescence light and the extinction light are measured with a common optical system and/or are measured simultaneously.

3. The method according to claim 1 or 2, wherein the irradiation of the sample

   i) is not conducted simultaneously with the first and second wavelengths; or
   ii) the irradiation with the second wavelength is conducted continuously, whereas the irradiation with the first wavelength is conducted intermittently, preferably periodically.

4. The method according to any one of the preceding claims, wherein

   i) the extinction light and the fluorescence light are measured by a common detector (53);
   ii) the extinction light is measured by a first detector (50) and/or a second detector (51) and fluorescence light of a first fluorescence wavelength is measured by the first detector (50) and fluorescence light of a second fluorescence wavelength is measured by the second detector (51); or
   iii) the extinction light is measured by a first detector (52), fluorescence light of a first fluorescence wavelength is measured by a second detector (51) and fluorescence light of a second fluorescence wavelength is measured by a third detector (50).

5. The method according to any one of the preceding claims, wherein the sample container (30) is a capillary (30).

6. The method according to any one of the preceding claims, wherein the sample container (30) is tempered, preferably lies on a tempering element (77) and is tempered by contact, wherein, further preferred, the irradiated light of the second wavelength is reflected back by the tempering element (77), again runs through the sample container (30) in opposite direction and exits as extinction light.

7. The method according to claim 6, wherein the tempering element (77) is made of a material

   i) which has little autofluorescence <1%, and/or
   ii) which has a high reflectivity > 30% in the wavelength range of the second wavelength and

   preferably comprises silicon or consists of pure silicon.

8. The method according to any one of the preceding claims, wherein the sample container (30) is shifted during a measuring period relatively to the irradiated light of the first and/or second wavelength and/or to the detector, is preferably driven back and forth several times and further preferably a plurality of sample containers or a plurality of capillaries (30) are scanned by said relative movement, wherein, during the measuring period, preferably a plurality of sample containers and/or the optical system are continuously driven back and forth several times and the measurements of the fluorescence light and /or the extinction light are conducted during the movement.

9. The method according claim 8, wherein

   i) a fluorescence value is determined by integrating the intensity of the fluorescence light over the shifting and/or
   ii) an extinction value is determined by integrating the intensity of the extinction light over the shifting.

10. The method according to any one of the preceding claims, wherein during a measuring period

    i) in order to determine the thermal stability the temperature of the samples is changed, preferably increased;
    ii) in order to determine chemical stability the concentration of denaturants in different liquid samples is chosen differently; and/or
    iii) in order to determine stability in terms of time the sample is kept at a substantially constant temperature for a time period of more than one hour.

11. The method according to any one of the preceding claims, wherein

    i) the second wavelength (20) is chosen such that less than 1%, 0.1%, 0.05% is absorbed by the sample or the particles in the sample;

ii) the light of the second wavelength and the light of the first wavelength are united to a collinear ray which is irradiated into the sample container; and/or

iii) the extinction light of the second wavelength, which is reflected back and leaves the sample container in the opposite direction to the irradiation direction, deviates from the irradiation direction 5° at most, preferably less than 2°, further preferred less than 1°.

12. An apparatus for the optical measurement of the stability and the aggregation of particles in a liquid sample (10), which is located in a sample container (30), in particular according to any one of the preceding claims, wherein the apparatus comprises:

a carrier element having a reflective surface (77) on which the sample containers (30) are arranged,
a first light source (40) for irradiating light of a first wavelength into the sample container to fluorescently excite the particles to be examined,
a second light source (41) for irradiating light of a second wavelength into the sample container to measure the scattering of the particles,
a first detector for measuring the excited fluorescence light which is radiated from the sample,
a second detector for measuring extinction light (22) at the second wavelength, wherein the irradiated light of the second wavelength (20) runs through the sample container (30), is reflected back from the reflective surface (77), runs again through the sample container in opposite direction and exits as extinction light, and
an evaluation means which is configured to determine the stability of the particles based on the measured fluorescence light and to determine the aggregation of the particles based on the measured extinction light.

13. The apparatus according to claim 12 having a tempering element having a reflective surface at which the irradiated light of the second wavelength is reflected back, wherein the reflective surface preferably consists of silicon, preferably crystalline silicon, and wherein the apparatus is preferably configured such that at least one sample container (30) is arranged at the surface for measuring, wherein the sample container (30) is preferably a capillary (30).

14. The apparatus according to claim 12 or 13 or the method according to any one of claims 1 to 11, wherein at least one groove (90) is formed at the surface of the tempering element and the irradiated light of the second wavelength (20) is reflected back by the bottom of the groove (90), wherein the groove (90) has preferably a width of 1-10mm and a depth of more than half of the coherence length of the light of the second wavelength.

15. Use of an apparatus according to any one of claims 12 to 14 for conducting a method according to any one of claims 1 to 11.

**Revendications**

1. Procédé pour la mesure optique d'au moins la stabilité et l'agrégation de particules dans un échantillon liquide (10), qui se trouve dans un récipient d'échantillonnage (30), le procédé présentant les étapes suivantes :

irradiation de l'échantillon (10) avec une lumière ayant au moins une première longueur d'onde (21), pour exciter les particules par fluorescence,
irradiation de l'échantillon (10) avec une lumière ayant au moins une deuxième longueur d'onde (20), pour étudier la dispersion des particules,
mesure de la lumière de fluorescence émise par l'échantillon (10), et
mesure de la lumière d'extinction (22) à la deuxième longueur d'onde, la lumière incidente ayant la deuxième longueur d'onde (20) traversant le récipient d'échantillonnage (30), étant réfléchie, traversant de nouveau le récipient d'échantillonnage dans la direction opposée, et sortant sous forme d'une lumière d'extinction,
la stabilité étant déterminée sur la base de la lumière de fluorescence mesurée et l'agrégation étant déterminée sur la base de la lumière d'extinction mesurée.

2. Procédé selon la revendication 1, dans lequel la lumière de fluorescence et la lumière d'extinction sont mesurées à l'aide d'un système optique commun et/ou mesurées simultanément.

3. Procédé selon la revendication 1 ou 2, dans lequel l'irradiation de l'échantillon

i) n'a pas lieu simultanément à la première longueur d'onde et à la deuxième longueur d'onde ; ou

ii) a lieu en permanence avec la deuxième longueur d'onde, l'irradiation à la première longueur d'onde s'effectuant en revanche d'une manière intermittente, de préférence périodique.

4. Procédé selon l'une des revendications précédentes, dans lequel

i) la lumière d'extinction et la lumière de fluorescence sont mesurées par un détecteur (53) commun ;

ii) la lumière d'extinction est mesurée par un premier détecteur (50) et/ou par un deuxième détecteur (51), et la lumière de fluorescence ayant une première longueur d'onde de fluorescence est mesurée par le premier détecteur (50) et la lumière de fluorescence ayant une deuxième longueur d'onde de fluorescence est mesurée par le deuxième détecteur (51) ; ou

iii) la lumière d'extinction est mesurée par un premier détecteur (52), la lumière de fluorescence ayant une première longueur d'onde de fluorescence est mesurée par un deuxième détecteur (51) et la lumière de fluorescence ayant une deuxième longueur d'onde de fluorescence est mesurée par un troisième détecteur (50).

5. Procédé selon l'une des revendications précédentes, dans lequel le récipient d'échantillonnage (30) est un capillaire (30).

6. Procédé selon l'une quelconque des revendications précédentes, dans lequel le récipient d'échantillonnage (30) est porté à l'équilibre de température, mis en place de préférence sur l'élément d'équilibrage de la température (77) et est porté à l'équilibre de température par contact, dans lequel l'élément d'équilibrage de la température réfléchit en outre de préférence la lumière incidente de la deuxième longueur d'onde, traverse de nouveau le récipient d'échantillonnage (30) dans la direction opposée, et sort sous forme d'une lumière d'extinction.

7. Procédé selon la revendication 6, dans lequel l'élément d'équilibrage de la température (77) est fabriqué en un matériau

i) présentant une faible fluorescence propre < 1 %, et/ou

ii) présentant un facteur de réflexion élevé > 30 %, dans la gamme de longueurs d'onde de la deuxième longueur d'onde, et

de préférence comprenant du silicium ou étant constitué de silicium pur.

8. Procédé selon l'une des revendications précédentes, dans lequel le récipient d'échantillonnage (30) est, pendant une période de mesure, déplacé par rapport à la lumière incidente ayant la première et/ou la deuxième longueurs d'onde et/ou par rapport au détecteur, de préférence est déplacé à plusieurs reprises dans un sens et dans l'autre, et de plus, de préférence, plusieurs récipients d'échantillonnage ou plusieurs capillaires (30) sont balayés par ce déplacement relatif, dans lequel, pendant la période de mesure, de préférence, plusieurs récipients d'échantillonnage et/ou le système optique sont déplacés en continu en avant et en arrière plusieurs fois et les mesures de la lumière de fluorescence et/ou de la lumière d'extinction sont effectuées pendant le mouvement.

9. Procédé selon la revendication 8, dans lequel

i) on détermine une valeur de fluorescence en intégrant l'intensité de la lumière de fluorescence sur le déplacement et/ou

ii) on détermine une valeur d'extinction en intégrant l'intensité de la lumière d'extinction sur le déplacement.

10. Procédé selon l'une des revendications précédentes, dans lequel, au cours d'une période de mesure

i) pour la détermination de la stabilité thermique, on modifie, de préférence on élève la température des échantillons ;

ii) pour la détermination de la stabilité chimique, on choisit à des valeurs différentes la concentration de dénaturants dans différents échantillons liquides ; et/ou

iii) pour la détermination de la stabilité dans le temps, on maintient l'échantillon sur un certain laps de temps, supérieur à une heure, essentiellement à température constante.

11. Procédé selon l'une des revendications précédentes, dans lequel

i) la deuxième longueur d'onde (20) est choisie de telle sorte que l'absorption par l'échantillon ou par les particules se trouvant dans l'échantillon soit inférieure à 1 %, à 0,1 %, à 0,05 %,

ii) la lumière ayant la deuxième longueur d'onde et la première longueur d'onde sont combinées pour obtenir un faisceau colinéaire, qui est envoyé dans le récipient d'échantillonnage, et/ou

iii) la lumière d'extinction ayant la deuxième longueur d'onde, qui est réfléchie et qui sort du récipient d'échantillonnage dans la direction opposée à la direction d'incidence, s'écarte d'au plus 5°, de préférence de moins de 2°, plus préférentiellement de moins de 1° de la direction d'incidence.

12. Dispositif pour la mesure optique de la stabilité et de l'agrégation de particules dans un échantillon liquide (10) qui se trouve dans un récipient d'échantillonnage (30), en particulier selon l'une des revendications précédentes, le dispositif comprenant :

un élément de support avec une surface réfléchissante (77) sur laquelle sont disposés les récipients d'échantillonnage (30),

une première source de lumière (40) pour envoyer une lumière ayant une première longueur d'onde dans le récipient d'échantillonnage, pour exciter par fluorescence les particules à étudier,

une deuxième source de lumière (41) pour envoyer une lumière ayant une deuxième longueur d'onde dans le récipient d'échantillonnage, pour mesurer la dispersion des particules,

un premier détecteur pour la mesure de la lumière de fluorescence excitée, qui est émise par l'échantillon,

un deuxième détecteur pour la mesure de la lumière d'extinction (22) à la deuxième longueur d'onde,

dans lequel la lumière incidente de la deuxième longueur d'onde (20) traverse le récipient d'échantillonnage (30), est réfléchie par la surface réfléchissante (77), traverse à nouveau le récipient d'échantillonnage dans la direction opposée et émerge en tant que lumière d'extinction, et

un dispositif d'évaluation, qui est configuré, sur la base de la lumière de fluorescence mesurée, pour déterminer la stabilité des particules et, sur la base de la lumière d'extinction mesurée, pour déterminer l'agrégation des particules.

13. Dispositif selon la revendication 12, comprenant un élément d'équilibrage de la température avec une surface réfléchissante émergente sur laquelle la lumière incidente de la seconde longueur d'onde est réfléchie, dans lequel la surface réfléchissante consiste de préférence en silicium, de préférence en silicium cristallin, et

dans lequel ledit dispositif est de préférence adapté pour placer au moins un récipient d'échantillonnage (30) sur ladite surface pour la mesure, ledit au moins un récipient d'échantillonnage (30) étant de préférence un capillaire (30).

14. Dispositif selon la revendication 12 ou 13 ou procédé selon l'une quelconque des revendications 1 à 11, dans lequel au moins une rainure (90) est formée sur la surface de l'élément d'équilibrage de la température, le récipient d'échantillonnage est disposé au-dessus de la rainure, et la lumière incidente de la seconde longueur d'onde (20) est réfléchie par le fond de la rainure (90), dans lequel la rainure (90) a de préférence une largeur comprise entre 1 et 10 mm et une profondeur supérieure à la moitié de la longueur de cohérence de la lumière de la seconde longueur d'onde.

15. Utilisation d'un dispositif selon la revendication 12 à 14 pour la mise en œuvre d'un procédé selon l'une des revendications 1 à 11.

Fig. 1

Fig. 2

Fig. 3

a)

b)

Helligkeit [I]

Position x

c)

Extinktion
$E = -\log(I_{(x)})/(I_{0(x)})$

Peakfläche

Referenzfläche

Position x

d)

$\int$ Extinktion (Peakfläche) -

$\int$ Extinktion (Referenzfläche)

0

Position x

Fig. 4

a)

100

21    21    21

23    23    23

14    15    16

30    30    30

77

80

b)

Helligkeit [I]

Integrierte Fläche

Position x

c)

Integrierte
Fluoreszenz

X

X

X

0

Position x

Fig. 5

Fig. 6

Fig. 7b

Fig. 7a

Fig. 8b

Fig. 8a

Fig. 9

Fig. 10

Temperatur-induzierter,
pufferabhängiger Aggregationsverlauf

Fig. 11

Fig. 12

Fig. 13

Fig. 14

Fig. 15

Fig. 16

Fig. 17a

Fig. 17b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140234865 A1
- DE 102007031244
- EP 2572787 A
- EP 2848310 A